# EUROPEAN PATENT APPLICATION

(11) **EP 4 446 763 A1**
(43) Date of publication of application: **16.10.2024**
(21) Application number: 22904230.4
(22) Date of filing: 06.12.2022
(51) Int. Cl.: G01R 31/392, G01R 31/379, G01R 31/3828, G01R 31/385, H01M 10/42, H01M 10/44, H01M 10/48, H02J 7/00

(54) **LEAD STORAGE BATTERY SYSTEM AND METHOD FOR ESTIMATING DETERIORATION OF LEAD STORAGE BATTERY**

(30) Priority: 10.12.2021 JP 2021200687
(71) Applicant: FURUKAWA ELECTRIC CO., LTD., Tokyo 100-8322 (JP); The Furukawa Battery Co., Ltd., Yokohama-shi, Kanagawa-ken 240-0006 (JP)
(72) Inventor: TANIMURA Yudai, Tokyo 100-8322 (JP); NAKAMURA Hideto, Tokyo 100-8322 (JP); KUTSUMA Ayaka, Tokyo 100-8322 (JP); SATO Toshiyuki, Yokohama-shi, Kanagawa 240-0006 (JP); YOSHIDA Hideaki, Nikko-shi, Tochigi 321-2336 (JP)
(74) Representative: Grünecker Patent- und Rechtsanwälte PartG mbB
(86) International application number: PCT/JP2022/044985
(87) International publication number: WO 2023/106302

(57) **Abstract**

Provided are a lead-acid battery system and a lead-acid battery life estimation method, which can contribute to improvement of reliability by more accurately estimating a degradation degree of a lead-acid battery regardless of a degradation cause. A transition determination unit (131) that determines switching of charging/discharging process of a lead-acid battery (B), a current value determination unit (132) that detects a change in a discharge current value during a discharge period of the lead-acid battery (B), a calculation unit (133) that, when the current value determination unit (132) determines that a change occurred in the discharge current value, calculates a CT value on the basis of a discharge current value acquired for each section divided by the change, and a degradation determination unit (135) that determines a degradation degree of the lead-acid battery (B) using the CT value calculated by the calculation unit (133) are included.

## Description

### Technical Field

Embodiments of the present invention relate to a lead-acid battery system and a lead-acid battery life estimation method.

### Background Art

In recent years, there have been an increasing number of power generation facilities using renewable energy such as sunlight and wind power. In such power generation facilities, the amount of power generation cannot be controlled, and thus storage batteries are used to level the power load. That is, when the amount of power generation is larger than the amount of consumption, the difference is charged into storage batteries, and when the amount of power generation is smaller than the amount of consumption, the difference is discharged from the storage batteries.

Examples of such storage batteries include lead-acid batteries and lithium-ion secondary batteries. These storage batteries for power storage are installed in houses, offices, and sites of factories, electric power companies, and the like. The storage batteries are assumed to be used in units of several years to 10 years from the start of operation.

When long-term use is assumed as described above, it is necessary to periodically perform maintenance and management (maintenance) after the start of operation. This is because in the case of various storage batteries as described above, it is known that degradation progresses with use and available battery capacity decreases. On the other hand, these storage batteries are not replaced immediately even if their capacity is lost after single discharge as in the primary battery, but are repeatedly used. Thus, it is required to appropriately ascertain the state of installed storage batteries.

When the storage battery is a lead-acid battery using lead, examples of the cause of the decrease in capacity include a decrease in adhesion between a positive electrode current collector and a positive active material. However, there is a possibility of the characteristics of the lead-acid battery not changing unless it comes close to the end of the lifespan of the lead-acid battery, and it may be difficult to determine the degradation degree of the lead-acid battery that causes the change. In particular, in the case of a bipolar lead-acid battery, degradation may rapidly progress, and it is required to estimate the degradation degree with higher accuracy.

Examples of a method for estimating the degradation degree of a storage battery include a method disclosed in PTL 1 below. In the invention described in PTL 1, in order to determine the lifespan of the storage battery, the charged electricity amount is measured and the temperature of the storage battery is measured. Then, the temperature of the storage battery obtained in advance is converted into the charged electricity amount at a constant temperature on the basis of the relationship with the integrated value of the charged electricity amount until reaching the end of its lifespan, and the lifespan of the storage battery is calculated.

### Citation List

### Patent Literature

PTL 1: JP H2-288075 A

### Summary of Invention

### Technical Problem

In the invention described in PTL 1, as described above, the lifespan of the storage battery is determined using the relationship with the temperature. However, for example, the degradation of the lead-acid battery is not only a decrease in adhesion between the positive electrode current collector and the positive active material as described above.

That is, examples of the cause of degradation of the bipolar lead-acid battery include peeling of the active material, softening of the active material, sulfation, and the like. In the case of these causes, an influence of a C rate and a depth of discharge (DOD) cannot be ignored, and the degree of influence on the degradation of the bipolar lead-acid battery changes for each discharging process. Therefore, a method for estimating the degradation degree of a lead-acid battery with higher accuracy is required.

An object of the present invention is to provide a lead-acid battery system and a lead-acid battery life estimation method, which can contribute to improvement of reliability by more accurately estimating a degradation degree of a lead-acid battery regardless of a degradation cause.

### Solution to Problem

A lead-acid battery system according to an aspect of the present invention includes: a transition determination unit configured to determine switching of a charging/discharging process of a lead-acid battery; a current value determination unit configured to detect a change in a discharge current value during a discharge period of the lead-acid battery; a calculation unit configured to, when the current value determination unit determines that a change has occurred in the discharge current value, calculate a CT value based on the discharge current value acquired for each section divided by the occurrence of the change; and a degradation determination unit configured to determine a degradation degree of the lead-acid battery using the CT value calculated by the calculation unit.

A lead-acid battery life estimation method according to an aspect of the present invention includes: determining whether or not a lead-acid battery is switched from a charging process to a discharging process; measuring a current in the discharging process when it is determined that the lead-acid battery is switched to the discharging process; integrating the measured discharge current values; determining whether the discharge current value has changed; executing a calculation process of a CT value using the integrated discharge current value when it is determined that the discharge current value has changed; determining whether the lead-acid battery is switched from the discharging process to the charging process; and calculating a sum of the CT values calculated so far when it is determined that the lead-acid battery is switched from the discharging process to the charging process.

A lead-acid battery life estimation method according to an aspect of the present invention includes: determining whether or not a lead-acid battery is switched from a charging process to a discharging process; when it is determined that the lead-acid battery has been switched to the discharging process, starting measurement of an elapse of an integration time in a discharge period of the lead-acid battery; measuring a current in the discharging process and integrating measured discharge current values; determining whether the discharge current value has changed; determining whether the lead-acid battery is switched from the discharging process to the charging process; ending the measurement of the integration time when it is determined that the lead-acid battery is switched from the discharging process to the charging process; converting the integration time into a capacity conversion time; and executing a calculation process of a CT value using a total discharge capacity obtained by multiplying the ascertained discharge current value by the capacity conversion time.

### Advantageous Effects of Invention

As described above, a lead-acid battery system according to an aspect of the present invention includes: a transition determination unit configured to determine switching of a charging/discharging process of a lead-acid battery; a current value determination unit configured to detect a change in a discharge current value during a discharge period of the lead-acid battery; a calculation unit configured to, when the current value determination unit determines that a change has occurred in the discharge current value, calculate a CT value based on the discharge current value acquired for each section divided by the occurrence of the change; and a degradation determination unit configured to determine a degradation degree of the lead-acid battery using the CT value calculated by the calculation unit. Therefore, by more accurately estimating the degradation degree of the lead-acid battery regardless of the cause of degradation, it is possible to contribute to improvement of reliability.

### Brief Description of Drawings

FIG. 1 is a block diagram illustrating an overall configuration of a lead-acid battery system according to an embodiment of the present invention;
FIG. 2 is a block diagram illustrating an internal configuration of a BMU according to the embodiment of the present invention;
FIG. 3 is a block diagram illustrating a detailed internal configuration of a state determination unit according to a first embodiment of the present invention;
FIG. 4 is an explanatory view illustrating a time course of charging/discharging process of the lead-acid battery in the first embodiment of the present invention;
FIG. 5 is a flowchart illustrating a flow of determining a degradation degree of a lead-acid battery using the lead-acid battery system according to the first embodiment of the present invention;
FIG. 6 is a flowchart illustrating a flow of determining a degradation degree of a lead-acid battery using the lead-acid battery system according to the first embodiment of the present invention;
FIG. 7 is a flowchart illustrating a flow of determining a degradation degree of a lead-acid battery using the lead-acid battery system according to the first embodiment of the present invention;
FIG. 8 is a flowchart illustrating a flow of determining a degradation degree of a lead-acid battery using the lead-acid battery system according to the first embodiment of the present invention;
FIG. 9 is a flowchart illustrating a flow of determining a degradation degree of a lead-acid battery using the lead-acid battery system according to the first embodiment of the present invention;
FIG. 10 is a block diagram illustrating a detailed internal configuration of a state determination unit according to a second embodiment of the present invention;
FIG. 11 is an explanatory view illustrating a time course of a charging/discharging process of a lead-acid battery in the second embodiment of the present invention;
FIG. 12 is a flowchart illustrating a flow of determining a degradation degree of a lead-acid battery using the lead-acid battery system according to the second embodiment of the present invention;
FIG. 13 is a flowchart illustrating a flow of determining a degradation degree of a lead-acid battery using the lead-acid battery system according to the second embodiment of the present invention;
FIG. 14 is a flowchart illustrating a flow of determining a degradation degree of a lead-acid battery using the lead-acid battery system according to the second embodiment of the present invention;
FIG. 15 is a flowchart illustrating a flow of determining a degradation degree of a lead-acid battery using the lead-acid battery system according to the second embodiment of the present invention;
FIG. 16 is a flowchart illustrating a flow of determining a degradation degree of a lead-acid battery using the lead-acid battery system according to the second embodiment of the present invention;
FIG. 17 is a flowchart illustrating a flow of determining a degradation degree of a lead-acid battery using the lead-acid battery system according to the second embodiment of the present invention; and
FIG. 18 is a flowchart illustrating a flow of determining a degradation degree of a lead-acid battery using the lead-acid battery system according to the second embodiment of the present invention.

### Description of Embodiments

Hereinafter, embodiments of the present invention will be described in detail with reference to the drawings. Note that the embodiments described below illustrate examples of the present invention. In addition, various changes or improvements can be added to the present embodiments, and a mode to which such changes or improvements are added can also be included in the present invention. These embodiments and modifications thereof are included in the scope and gist of the invention, and are included in the scope of the invention described in the claims and its equivalents.

### (First Embodiment)

### [Configuration of Lead-Acid Battery System]

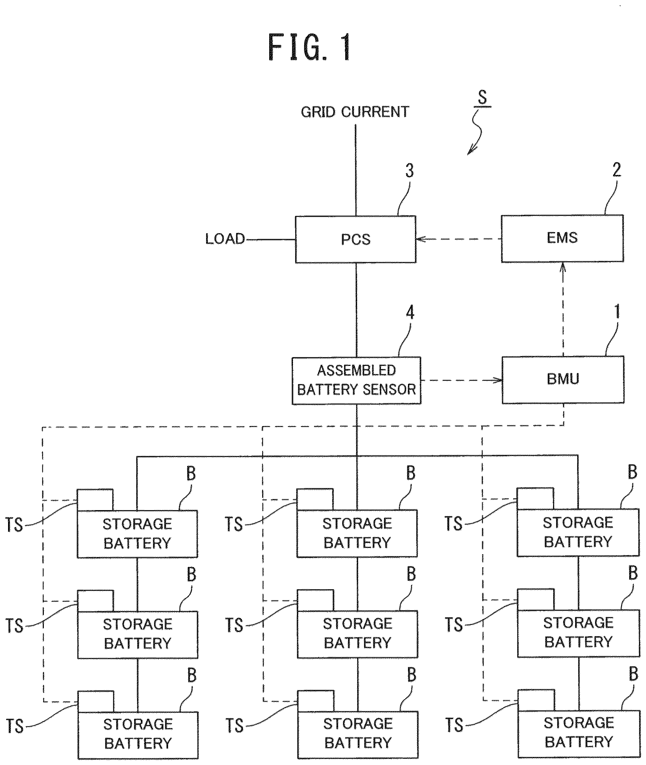

An overall configuration of a lead-acid battery system S according to an embodiment of the present invention will be described with reference to FIG. 1. FIG. 1 is a block diagram illustrating an overall configuration of the lead-acid battery system S according to the embodiment of the present invention.

The lead-acid battery system S is a system that stores, in the lead-acid battery B, a system current generated by various power plants such as thermal power plants or renewable energy such as wind power generation and transmitted. The lead-acid battery system S is a system that transmits power stored in the lead-acid battery B to a load such as a home, an office, or a factory as necessary. The lead-acid battery system S according to the embodiment of the present invention includes a BMU 1, an EMS 2, a PCS 3, and an assembled battery sensor 4 in addition to the lead-acid battery B.

The BMU 1 is a battery management unit, and is an apparatus that manages a voltage of each of cells constituting the lead-acid battery B, a temperature of the entire lead-acid battery B, and the like. Therefore, the BMU 1 is configured to enable the state of the lead-acid battery B to be ascertained via a sensor that acquires various types of information provided in the lead-acid battery B as will be described below. In addition, the BMU 1 according to the embodiment of the present invention includes, for example, a degradation estimation program necessary for estimating the degradation state in order to manage the degradation state of the lead-acid battery B.

Note that the function of the BMU 1 is not limited to the function described here. The BMU 1 may include other functions such as managing voltage balance in each cell, for example.

As the BMU 1, a personal computer (PC) or a microcomputer is used, for example. The BMU 1 may be installed in the vicinity of the lead-acid battery B, or may be configured to be managed on a cloud or to be managed remotely. A detailed configuration of the BMU 1 will be described below.

The EMS 2 is a so-called energy management system, and is a system through which a use state of power energy is ascertained, managed, and optimized. In addition, the PCS 3 is a power conditioning system, and serves a role of converting a direct current generated by the system current or the like into an alternating current and adjusting the alternating current to a stable output suitable for output to the load or storage in the lead-acid battery B.

The lead-acid battery B is a secondary battery using lead as an electrode. As the lead-acid battery B, a bipolar lead-acid battery is preferably applied, but any structure may be used. In addition, the number of installations, an installation method, and the like are not limited, and can be arbitrarily set. In the embodiment of the present invention, three lead-acid batteries (simply referred to as "storage batteries" in FIG. 1) B connected in series are connected in parallel.

As described above, in the lead-acid battery system S according to the embodiment of the present invention, the plurality of lead-acid batteries B are configured as an assembled battery, and the assembled battery sensor 4 for measuring a total voltage and a charge/discharge current of the assembled battery is connected. The information on the total voltage and the charge/discharge current measured by the assembled battery sensor 4 is transmitted to the BMU 1 and used as information for estimating the degradation degree of the lead-acid battery B in the BMU 1.

Furthermore, in the case of the lead-acid battery B according to the embodiment of the present invention, a temperature sensor TS for measuring the temperature of each lead-acid battery B is provided. As illustrated in FIG. 1, the temperature sensor TS is provided for each lead-acid battery B, and the temperature of the lead-acid battery B is also measured for each lead-acid battery B.

However, the temperature sensor TS may be provided not for each individual lead-acid battery B as described above, but for example, for each unit that is a set of lead-acid batteries. For the temperature of the lead-acid battery B to be measured, the temperature of a representative lead-acid battery B among the set of lead-acid batteries B may be measured, or the ambient temperature of the lead-acid battery B may be measured.

In the embodiment of the present invention, a direct current from a system current such as power generated in a power plant such as thermal power or from renewable energy is converted into an alternating current in the PCS 3, and output to a load and storage in the lead-acid battery B are performed.

In the BMU 1, as will be described below, switching of a charging/discharging process of the lead-acid battery B, the degradation degree, and the like are ascertained, and an operation command is issued to the EMS 2 in accordance with the state of the lead-acid battery B. This operation command is further transmitted to the PCS 3 to appropriately issue a command for charging or discharging with respect to the lead-acid battery B and perform the above-described output to the load and the like.

As illustrated in FIG. 1, in the embodiment of the present invention, five components of the lead-acid battery system S are the BMU 1, the EMS 2, the PCS 3, the assembled battery sensor 4, and the lead-acid battery B. However, the components of the lead-acid battery system S are not limited thereto.

In addition, it is also possible to impart the functions of the EMS 2 and the PCS 3 to the BMU 1, and in this case, the lead-acid battery system S includes the BMU 1, the assembled battery sensor 4, and the lead-acid battery B. Further, the assembled battery sensor 4 may not be independent, and a sensor for measuring current and voltage may be provided in each lead-acid battery B, for example.

In FIG. 1, the components are connected by a broken line arrow or a solid line. Here, a broken line arrow indicates a flow of information, and information is transmitted in a direction of the arrow. On the other hand, a solid line indicates a flow of a current. Therefore, the power transmitted from the system current temporarily enters the PCS 3, the above-described processing is performed, and the power is stored in the lead-acid battery B via the assembled battery sensor 4. Then, the power stored in the lead-acid battery B is discharged and transmitted to a load.

Furthermore, as described above, the BMU 1 and the like may not be installed in the vicinity of the lead-acid battery B, and may be operable on a cloud or remotely. Therefore, information may be exchanged in the lead-acid battery system S either in a wired or wireless manner.

### [Internal Configuration of BMU]

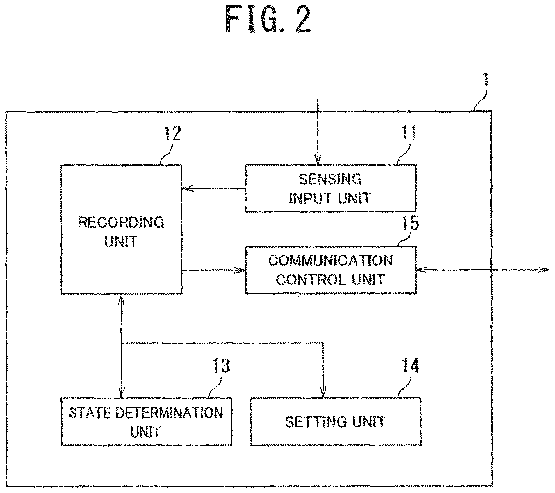

Next, the BMU 1 will be described in more detail. FIG. 2 is a block diagram illustrating an internal configuration of the BMU 1 according to the embodiment of the present invention. The BMU 1 includes a sensing input unit 11, a recording unit 12, a state determination unit 13, a setting unit 14, and a communication control unit 15.

The sensing input unit 11 receives information related to a measurement value such as a current measured via the above-described various sensors provided in the assembled battery sensor 4 or the lead-acid battery B. In addition, the sensing input unit 11 may be set in such a manner that the information is continuously input or input during two times arbitrarily set in advance. The sensing input unit 11 may also be set in such a manner that the information is periodically input.

The recording unit 12 is configured from, for example, a semiconductor or a magnetic disk. The recording unit 12 records information regarding measurement values from various sensors received by the sensing input unit 11, information exchanged by the BMU 1 with the EMS 2, and the like.

The state determination unit 13 determines the state of the lead-acid battery B. The determination is performed as needed during normal operation as will be described below, for example. The determination is also performed when maintenance is performed on the lead-acid battery system S.

The setting unit 14 sets, for example, various thresholds to be described below, which are used when the degradation degree of the lead-acid battery B is determined by the state determination unit 13. In setting the thresholds, an input unit and a display unit that are not illustrated in FIG. 2 are used.

The communication control unit 15 is a unit such as a LAN card or a modem, and is a unit that enables the BMU 1 to be connected to a communication network such as the Internet or a LAN wirelessly or by wire. In addition, by mediating connection with the EMS 2, the PCS 3, or the assembled battery sensor 4, information can be exchanged therebetween.

As described above, a PC or the like is used for the BMU 1. In FIG. 2, only the directly related functions in the embodiment of the present invention are illustrated, and the illustration of each unit normally included in the PC or the like is omitted. Therefore, each unit that is not illustrated will be described hereinafter.

The BMU 1 includes a configuration in which a central processing unit (CPU), a read only memory (ROM), a random access memory (RAM), and an input/output interface are connected via a bus. In addition, an input unit and a display unit used by a person who manages the lead-acid battery system S are connected to the input/output interface, and each unit illustrated in FIG. 2 described above is connected to the input/output interface.

The CPU reads out and executes a boot program for starting up the BMU 1 from the ROM based on an input signal from the input unit, and reads out various operating systems stored in the recording unit 12. The CPU may control the lead-acid battery B or the like based on an input signal from another external device that is not illustrated in FIG. 2 via the input unit or the input/output interface.

Further, the CPU reads programs and data stored in the RAM, the recording unit 12, or the like, and loads the programs and data into the RAM. The CPU is a processing device that realizes a series of processes such as management of the lead-acid battery B and calculation and processing of data necessary for estimating the degradation degree of the lead-acid battery B based on a command of a program read from the RAM.

The input unit includes, for example, an input device such as a keyboard or a touch panel to which a person who manages the lead-acid battery system S inputs various operations. When the administrator operates the input unit, an input signal is created and transmitted to the CPU via the bus.

The display unit is, for example, a liquid crystal display. The display unit receives an output signal from the CPU via the bus, and displays, for example, information on the degradation degree of the lead-acid battery B constituting the lead-acid battery system S or a processing result of the CPU.

In a case where the BMU 1 itself is operated by remote control, for example, the input unit and the display unit do not have to be provided inside the BMU 1. The BMU 1 may include functions other than those of the above-described units.

### [Internal Configuration of State Determination Unit]

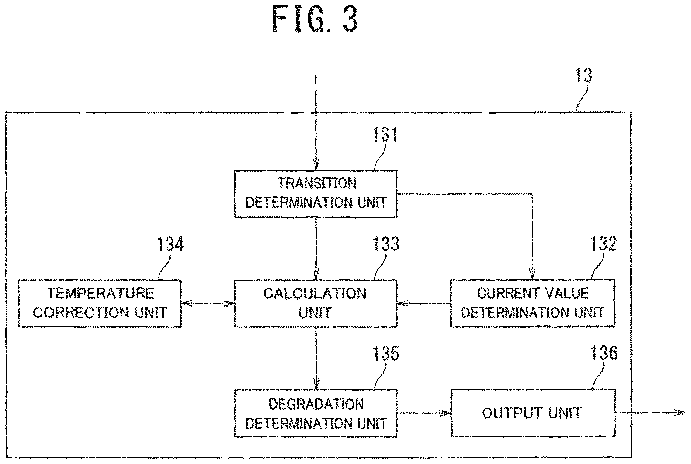

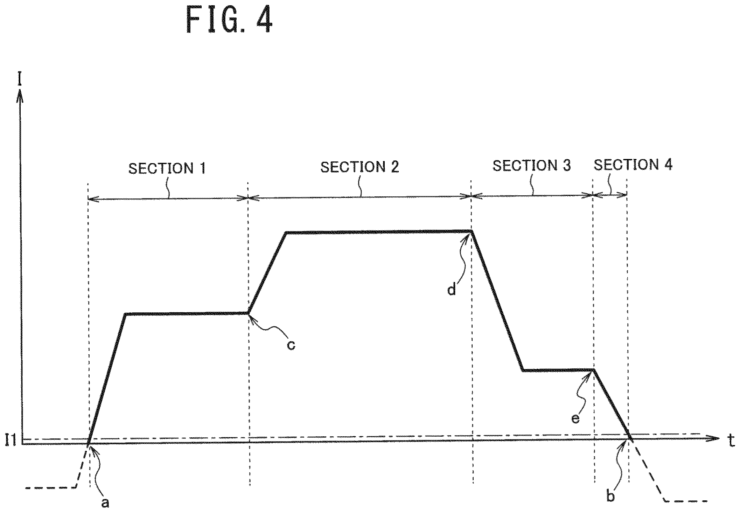

Next, the internal configuration of the state determination unit 13 will be described in more detail with reference to FIG. 4 as appropriate. FIG. 3 is a block diagram illustrating a detailed internal configuration of the state determination unit 13 according to the first embodiment of the present invention. FIG. 4 is an explanatory view illustrating a time course of charging/discharging process of the lead-acid battery B in the first embodiment of the present invention.

The state determination unit 13 includes a transition determination unit 131, a current value determination unit 132, a calculation unit 133, a temperature correction unit 134, a degradation determination unit 135, and an output unit 136. The output unit 136 transmits the result of the degradation determination of the lead-acid battery B determined by the state determination unit 13 to a display unit (not illustrated).

The transition determination unit 131 determines whether or not the lead-acid battery B has transitioned from the charging process to the discharging process. That is, in the embodiment of the present invention, the amount of discharge in the lead-acid battery B is used to determine the degradation degree of the lead-acid battery B. More specifically, the lead-acid battery B repeats the charging process and the discharging process, but the charge amount in the charging process is omitted and only the discharge amount is used.

That is, the transition determination unit 131 determines whether or not the lead-acid battery B has transitioned to the discharging process, and when it is determined that the lead-acid battery B has transitioned to the discharging process, the state determination unit 13 starts execution of the process of determining the degradation degree of the lead-acid battery B.

Here, in FIG. 4, a vertical axis represents a current value I, a horizontal axis represents time t, and a time course of the charging/discharging process in the lead-acid battery B is illustrated from left to right. In the case of the discharging process, the current value measured by the assembled battery sensor 4 shows a value of - (minus), and in the case of the charging process, the current value shows + (plus). Therefore, in FIG. 4, the current value illustrated upward from the horizontal axis is illustrated as a negative current value in consideration of visibility.

Therefore, in FIG. 4, the discharging process executed in the lead-acid battery B is indicated by a solid line on the upper side of the horizontal axis, and the charging process is indicated by a broken line on the lower side. From this, it can be seen that, in the case of the charging/discharging process of the lead-acid battery B illustrated in FIG. 4, the charging process was first performed, but thereafter, the discharging process was executed, and the transition to the charging process was performed again. It is also illustrated that a discharge current value during a discharge period is not constant but changes.

Here, an area surrounded by the discharge current amount and the horizontal axis indicating the time t, which is indicated by transition from the charging process to the discharging process and transition from the discharging process to the charging process while changing the discharge current value, indicates the discharge capacity (discharge current value) integrated in the so-called discharging process.

A current value I1 indicated by an alternate long and short dash line is drawn in parallel with the horizontal axis immediately above the horizontal axis indicating the elapse of time. The current value I1 indicates a threshold for determining whether or not to terminate the processing for ascertaining the current amount. That is, it is assumed that the measurement result of the current value in the assembled battery sensor 4 does not indicate 0 even when there is no charge or discharge in terms of operation (the current value is 0). Therefore, as the current value I1, a small value such as substantially 0 is set in the setting unit 14. Hereinafter, the value set in this manner is referred to as a "threshold I1".

The transition determination unit 131 acquires information on the charge/discharge current value measured in the assembled battery sensor 4, and determines whether or not the current value is equal to or less than a preset threshold. When the transition determination unit 131 determines that the measured current value is equal to or less than the threshold, it can be ascertained that the charging/discharging process in the lead-acid battery B has transitioned from the charging process to the discharging process. In FIG. 4, for example, the position is indicated by a reference sign a.

That is, the "threshold" here is a value for determining whether or not the lead-acid battery B has transitioned from the charging process to the discharging process. The "threshold" is a value for determining whether the current value of the lead-acid battery B measured in the assembled battery sensor 4 has transitioned from plus to minus.

The transition determination unit 131 also determines whether the current value is smaller than the threshold I1. As described above, this is performed to determine whether or not to execute processing of continuously ascertaining the discharge current amount necessary for processing of determining the degradation degree of the lead-acid battery B after the lead-acid battery B transitions from the charging process to the discharging process.

On the other hand, the position indicated by a reference sign b is a position where the lead-acid battery B has transitioned from the discharging process to the charging process, and the transition determination unit 131 also determines the transition from the discharging process to the charging process. Specifically, this is a case where the current value measured in the assembled battery sensor 4 is not smaller than the threshold, that is, is larger than the threshold. In this way, when the lead-acid battery B shifts from the charging process to the discharging process and further transitions from the discharging process to the charging process, the state determination unit 13 executes a process of determining the degradation degree of the lead-acid battery B using the measured current value or the like.

However, the degradation degree of the lead-acid battery B is not determined by integrating the discharge current value with the discharge period as one section. This is because the degradation degree can be determined more accurately by dividing the discharge period into a plurality of sections and using the discharge current value acquired in each section.

In addition, by dividing the discharge period into a plurality of sections in this manner, it is possible to reliably integrate the discharge current amount in a case where the change in the discharge current amount is small, and this also ultimately contributes to accurately determining the degradation degree.

Therefore, in the embodiment of the present invention, the presence or absence of a change in the discharge current value is used as a method of dividing the discharge period into a plurality of sections. Therefore, the state determination unit 13 is provided with a current value determination unit 132. The current value determination unit 132 determines whether there is a change in the discharge current value within the discharge period. Then, as described below, when it is determined that the discharge current value has changed, a time point at which the discharge current value has changed is divided as one period in the discharge period.

That is, the current value determination unit 132 determines whether or not the discharge current value has changed from when the state of the lead-acid battery B transitions from the charging process to the discharging process to when the state transitions from the discharging process to the charging process and the discharging process is completed. Then, every time it is determined by the current value determination unit 132 that a change in the discharge current value has occurred, the discharge current value is measured and integrated as one section, and the temperature of the lead-acid battery B is measured.

Here, in the embodiment of the present invention, as illustrated in FIG. 4, the discharge period is divided into four. That is, in the explanatory diagram of FIG. 4, a period from a time point of transition from the charging process to the discharging process, to a time point the discharge current value increases and becomes a constant value and turns to increase again is defined as one section, which is represented as "section 1". Then, a period from when the discharge current value indicates a constant value after turning to the increase, and turning to the decrease is referred to as "section 2". In addition, a period from when the discharge current value decreases to when the discharge current value indicates a constant value and further decreases is referred to as "section 3", and a period from when the discharging process transitions to the charging process is referred to as "section 4".

As described above, the current value determination unit 132 according to the embodiment of the present invention collectively sets the section in which the discharge current value changes and the section in which the discharge current value does not change as one section, and determines that the change in the discharge current value has occurred at the time point the one section in which the transition from the section in which the discharge current value does not change to the section in which the discharge current value changes again ends.

In the current value determination unit 132, the determination on the increase and decrease of the discharge current value is executed as follows in the discharge period in which the charging process transitions to the discharging process and then the discharging process transitions to the charging process again. Specifically, for the discharge current value measured at predetermined intervals, the current value determination unit 132 determines whether a value obtained by subtracting the previously measured discharge current value (previous time) from the currently measured discharge current value is positive or negative.

That is, as a result of the calculation process, in the case of a positive value, the current discharge current value indicates a larger value than the previous discharge current value, so that it can be determined that the discharge current value is increasing. On the contrary, in the case of a negative value, the previous discharge current value indicates a larger value than the current discharge current value, so that it can be determined that the discharge current value is decreasing.

On the other hand, when the currently measured discharge current value and the previously measured discharge current value are the same value, it can be determined that there is no change in the measured discharge current value and the measured discharge current value is constant. This state is a state in which the transition of the discharge current value is illustrated in parallel with the horizontal axis indicating the time t in the explanatory diagram illustrated in FIG. 4.

However, although it is described here that the discharge current value indicates a "constant value", the discharge current value is not exactly the same value in many cases when actually measured. If it is determined that the "constant value" cannot be determined unless the currently measured discharge current value and the previously measured discharge current value are exactly the same value, the determination process of the current value determination unit 132 is inevitably very delicate, which is not practical as the processing of the lead-acid battery system S.

Therefore, the "constant value" here is a concept including a certain discharge current value I2. That is, the discharge current value I2 is a difference between the currently measured discharge current value and the previously measured discharge current value, and the discharge current value corresponding to the positive discharge current value I2 and the negative discharge current value I2 set in advance around the "constant value" is also treated as being included in the "constant value". For the reasons described above, the value of the discharge current value I2 is a small value to such an extent that the current value determination unit 132 does not determine that the discharge current value increases or decreases.

Therefore, when the difference between the currently measured discharge current value and the previously measured discharge current value falls within the width of the positive and negative discharge current value I2, that is, the absolute value of the discharge current value I2, the current value determination unit 132 determines that both the currently measured discharge current value and the previously measured discharge current value are "constant values".

Here, the current value determination unit 132 determines that the discharge current value has changed by shifting from a section in which the discharge current value does not change to a section in which the discharge current value changes. However, for example, the determination may also be executed at a time point when the discharge current value changes from an increase to a constant value or at a time point when the discharge current value changes from a decrease to a constant value.

In this example, the current value determination unit 132 determines that the discharge current value has changed when the transition determination unit 131 determines that the charging process has transitioned to the discharging process. However, this determination may be made when the transition determination unit 131 performs a determination process as to whether the discharge current value is smaller than the threshold I1 and determines that the current value is less than the threshold I1.

The calculation unit 133 of the state determination unit 13 calculates a value to be a determination criterion when the degradation determination unit 135 in the subsequent stage determines the degradation degree of the lead-acid battery B. The CT value is used as the determination criterion in the embodiment of the present invention. Here, the CT value is a value indicating capacitance turn-over, which is represented by a value obtained by dividing the total discharge capacity by the rated capacity of the lead-acid battery. The CT value is one of indices capable of indicating the state of the lead-acid battery B repeatedly used in the charging/discharging process.

That is, in the lead-acid battery B that repeats charging and discharging cycles, the number of times of discharging (the number of cycles) is determined under a certain condition. For example, when a certain lead-acid battery is described to be usable for 4500 cycles when used under the operation conditions of 25°C and a depth of discharge of 70%, the lead-acid battery can repeat the charging/discharging process 4500 times before the end of lifespan under this condition.

Therefore, if the total number of cycles up to the end of lifespan is known in advance and the number of cycles by use up to the present can be ascertained, the lifespan of the lead-acid battery B can be ascertained. Therefore, the approximate lifespan can be ascertained using a value obtained by dividing the number of charge/discharge cycles so far by the total number of cycles.

In addition, when the total discharge amount is known, if the discharge amount so far can be known, the approximate lifespan can be known even if a value obtained by dividing the discharge amount so far by the total discharge amount is used. The value ascertained in this manner is a so-called CT value, and in the embodiment of the present invention, this CT value is used when determining the degradation degree of the lead-acid battery B.

The calculation unit 133 calculates the CT value for each section divided based on the determination by the current value determination unit 132 that there is a change in the discharge current value. The sum of the CT values in the respective sections is defined as the CT value in one discharge period. As described above, in order to accurately ascertain the degradation degree of the lead-acid battery B, it is necessary to accurately ascertain the number of cycles or the amount of discharge in the lead-acid battery B used up to the present as much as possible.

Therefore, in the embodiment of the present invention, the CT value in each section is calculated by dividing one discharge period into a plurality of sections in which the discharge current value changes, so that the CT value in the discharge period ascertained as the sum is calculated with higher accuracy.

In order to ascertain the number of cycles or the amount of discharge, it is necessary to appropriately handle various conditions, particularly the depth of discharge. Therefore, when the state determination unit 13 (calculation unit 133) calculates the CT value, first, as preparation for the calculation, information on the discharge current value and the temperature when the discharging process is executed is acquired.

In the lead-acid battery system S according to the embodiment of the present invention, the discharge current value is measured by the assembled battery sensor 4, and the temperature is measured by the temperature sensor TS provided in each lead-acid battery B. Then, these pieces of information are transmitted to the BMU 1 and recorded in the recording unit 12 via the sensing input unit 11.

The discharge current values are sequentially integrated. This is because the CT value in the discharging process in one section is calculated as described above. Therefore, all the discharge current values in the discharging process in one section are integrated.

For the integration of the discharge current value, for example, the discharge current value recorded in the recording unit 12 may be ascertained in the calculation unit 133 each time of measurement, and the discharge current value may be integrated in the calculation unit 133. Alternatively, the measured current value may be integrated and recorded in the recording unit 12.

Until the current value determination unit 132 determines that a change has occurred in the discharge current value, that is, until the discharge current value changes and is divided into one section, acquisition of the above-described information on the discharge current value and temperature is continued. Then, when the time to be divided into one section comes, next, the calculation unit 133 calculates the depth of discharge based on the amount of discharge in the discharging process.

This is so-called raw information reflecting the situation in which the lead-acid battery B has performed the discharging process. Then, based on the calculated depth of discharge, the calculation unit 133 further calculates a charge/discharge rate, a so-called C rate, from the magnitude of the current value when the value of the discharge current is measured in the assembled battery sensor 4. This is because the depth of discharge described above is affected by the value of the C rate.

Note that the C rate calculated here may be a value at a certain time point, or may be calculated as, for example, an average value on the basis of the C rate calculated each time the discharging process is executed.

In addition, the C rate may be calculated by the calculation unit 133 or may be ascertained by storing the relationship between the depth of discharge and the C rate in the recording unit 12 in advance and the calculation unit 133 retrieves the relationship between the depth of discharge and the C rate from the recording unit 12.

Then, the value of the depth of discharge is corrected using the calculated C rate. The calculation unit 133 corrects the value of the depth of discharge using the C rate, whereby an appropriate depth of discharge can be obtained in the discharge period in which the CT value is calculated.

Using the value of the depth of discharge corrected by the C rate, the calculation unit 133 calculates the CT value in the current section. Then, the CT value calculation process by the calculation unit 133 is executed for each section as long as the discharge period continues.

Next, when the transition determination unit 131 determines that the lead-acid battery B has transitioned from the discharging process to the charging process, the calculation unit 133 ends the calculation of the CT value for each section. Then, the calculation unit 133 adds all the plurality of CT values calculated for each section of the discharge period. The CT value obtained by adding is the total discharge capacity in the discharge period or the number of cycles.

Here, the CT value is a value that increases every time it is calculated. Therefore, by adding the CT value calculated according to the execution of the current discharging process to the CT value calculated based on the previous discharging process, the total CT value in the discharging process executed so far can be calculated. The processing of the calculation unit 133 described above is expressed as follows. CT value=previous CT value+integrated discharge capacity×Kdod (c) / reference discharge capacity

Here, "Kdod(c)" in Equation 1 indicates a value after the depth of discharge is corrected using the C rate. The reference discharge capacity is calculated by multiplying the rated capacity (Ah) by the depth of discharge (%) as a reference.

The discharge current value used to calculate the CT value needs to be corrected depending on the temperature. Therefore, the temperature correction unit 134 corrects the discharge current value so that the discharge current value is appropriately integrated.

That is, the temperature correction can be performed by the temperature correction unit 134 each time the discharge current value is measured and integrated. Equation 1 described above is an equation used when temperature correction is performed at the time of integration of discharge current values, and "integrated discharge capacity" is a value after temperature correction has already been executed.

Here, for example, with a predetermined temperature at which the degradation of the lead-acid battery B is accelerated as a boundary, the temperature correction unit 134 performs correction using a coefficient of a large value when the temperature is equal to or higher than the predetermined temperature and using "1" as the coefficient when the temperature is lower than the predetermined temperature.

On the other hand, the temperature correction unit 134 can also execute the temperature correction process on the discharge current value integrated at the time of executing the depth of discharge correction using the C rate. An equation used when the calculation unit 133 executes the CT value calculation process at that time is as follows. In the following Equation 2, "Kt" represents a temperature correction coefficient. CT value=previous CT value+integrated discharge capacity×Kdod (c) / reference discharge capacity

That is, the "integrated discharge capacity" in Equation 2 is not a value subjected to temperature correction by the temperature correction unit 134 when the discharge current value is measured and integrated, but is simply an integrated value. After all the discharge current values are integrated, the temperature correction process is collectively performed.

When the CT value calculation process is completed by the calculation unit 133, the value is transmitted to the degradation determination unit 135. The degradation determination unit 135 determines the degradation degree of the lead-acid battery B using the calculated CT value.

Specifically, for example, the determination can be performed by comparing the calculated CT value with a threshold set as a reference for determining the lifespan. This threshold is set in advance by the setting unit 14. An operator or the like of the lead-acid battery system S is notified of the determination result via the output unit 136.

As a mode of notifying the degradation degree which is a result of the determination, for example, various modes such as a mode represented by a numerical value on the display unit, a mode represented by a symbol such as "○" or "×", and a mode represented by a graph or the like can be adopted.

### [Operation]

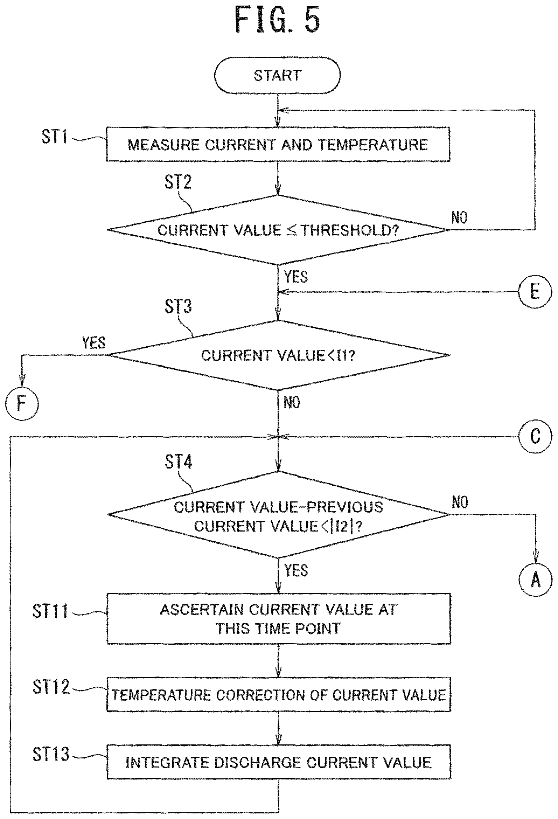

Next, a flow in which the BMU 1 determines the degradation degree of the lead-acid battery B will be described with reference to FIGS. 5 to 9. FIGS. 5 to 9 are flowcharts illustrating the flow of determining the degradation degree of the lead-acid battery B using the lead-acid battery system S according to the first embodiment of the present invention, and are the case of using the above-described Equation 1.

First, the current value of the lead-acid battery B is measured by the assembled battery sensor 4, and the temperature of the lead-acid battery B is measured by the temperature sensor TS provided in the lead-acid battery B (ST1). Information regarding the current value and the temperature measured by each sensor is transmitted to the BMU 1 and recorded in the recording unit 12 via the sensing input unit 11.

Then, the transition determination unit 131 constituting the state determination unit 13 determines whether or not the lead-acid battery B has transitioned from the charging process to the discharging process, that is, whether or not the current value measured in the assembled battery sensor 4 is equal to or less than the threshold (ST2).

If the value of the current value is larger than the threshold (NO in ST2), it is determined that the charging process is continuously executed in the lead-acid battery B, and the process returns to step ST1 to continue the measurement of the current value and the temperature.

When it is determined that the current value measured by the transition determination unit 131 is equal to or less than the threshold (YES in ST2), it is determined that the lead-acid battery B has transitioned from the charging process to the discharging process. Further, in order to determine whether or not to continuously execute the process of ascertaining the current value, the transition determination unit 131 determines whether or not the discharge current value is a value smaller than the threshold I1 (ST3).

If it is determined by the transition determination unit 131 that the discharge current value is not smaller than the threshold I1 (NO in ST3), the discharging process is continuously executed. Therefore, integration process of the discharge current value necessary for determining the degradation degree of the lead-acid battery B is started from here.

That is, first, the current value determination unit 132 determines whether or not there is a change in the measured discharge current value (ST4). Specifically, it is determined whether the discharge current value indicates a constant value. As described above, the constant value also includes the discharge current value I2 having a preset plus or minus value. Therefore, as illustrated in step ST4 of FIG. 5, it is determined whether or not the difference between the currently measured discharge current value and the previously measured discharge current value is smaller than the absolute value 12.

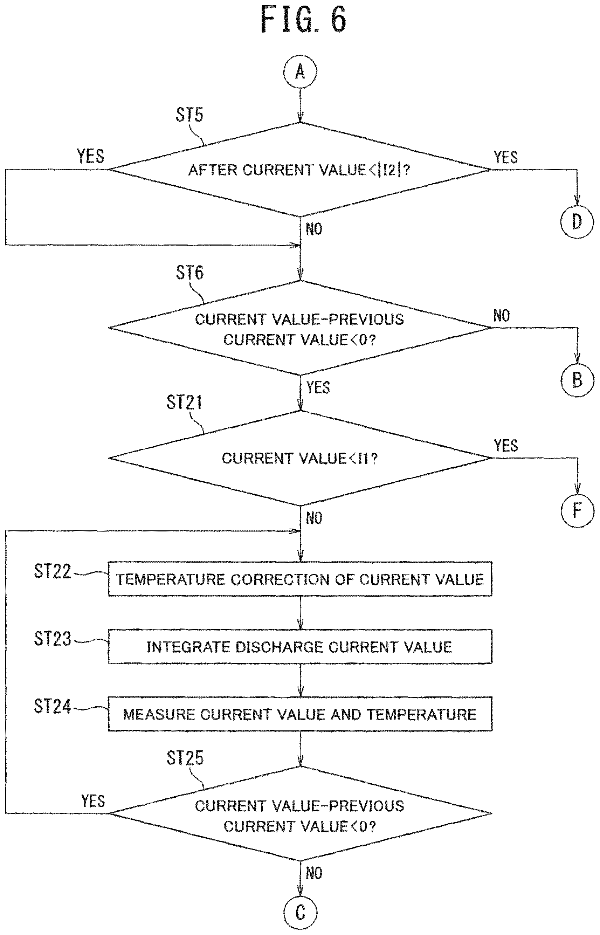

When the difference between the discharge current values is not smaller than the absolute value of the discharge current value I2 (NO in ST4), the measured discharge current value is not included in a constant value, but is increased or decreased. Therefore, next, it is determined whether or not the determination is processing performed after the determination as to whether or not the discharge current value indicates a constant value (ST5 in FIG. 6).

That is, it is checked whether the determination by the current value determination unit 132 that the measured discharge current value is not a value smaller than the absolute value of the discharge current value I2 corresponds to the determination at the time when the discharge current value increases or decreases from a constant value.

If this check corresponds to the determination at the time point when the discharge current value starts increasing or decreasing from a constant value (YES in ST5), one section is divided at this time point as described below, and the processing proceeds to the CT value calculation process by the calculation unit 133 in the section.

On the other hand, when the check does not correspond to the determination at the time when the discharge current value starts increasing or decreasing from the constant value (NO in ST5), it can be seen that the change amount of the discharge current value before the discharge current value indicates the constant value increases or decreases.

Then, the current value determination unit 132 determines whether the currently measured discharge current value is smaller than the previously measured discharge current value (ST6). This determination makes it clear whether the state of the measured discharge current value tends to increase or decrease. Here, first, a case where the discharge current value increases will be described.

That is, this state is a state in which the lead-acid battery B transitions from the charging process to the discharging process in the section 1 of the explanatory diagram of FIG. 4, and the value of the discharge current value increases but has not yet reached a constant value.

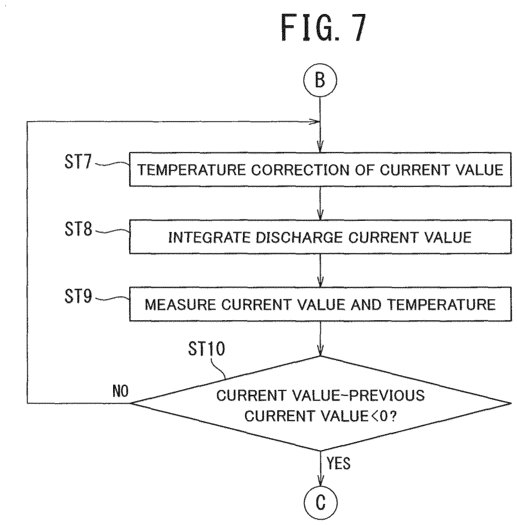

If it is determined by the current value determination unit 132 that the discharge current value measured by the assembled battery sensor 4 has increased (NO in ST6), the temperature correction unit 134 performs temperature correction on the discharge current value measured by the assembled battery sensor 4 (ST7 in FIG. 7). Then, the discharge current value subjected to the temperature correction process is integrated and recorded in the recording unit 12 (ST8). That is, every time the discharge current value is measured in the assembled battery sensor 4, temperature correction is performed, and the corrected discharge current value is integrated.

Then, the discharge current value and the temperature are measured again (ST9). Thereafter, the current value determination unit 132 again determines whether the currently measured discharge current value is smaller than the previously measured discharge current value (ST10).

If the current value determination unit 132 determines that the discharge current value has increased (NO in ST10), the process returns to step ST7. Subsequently, the respective processes of the temperature correction process, the integration process, the discharge current value, and the temperature measurement process of the measured discharge current value are executed.

On the other hand, when the previous discharge current value is subtracted from the current discharge current value and the value is less than 0 (YES in ST10), the process returns to step ST4 illustrated in FIG. 5. Then, the current value determination unit 132 determines again whether the difference between the currently measured discharge current value and the previously measured discharge current value is a value smaller than the absolute value I2.

As described above, the determination process by the current value determination unit 132 is determination of whether or not the difference between the measured discharge current value and the previously measured discharge current value does not change and indicates a constant value. Therefore, if the absolute value is deviated from the absolute value I2 (NO in ST4), the state in which the discharge current value is increased or decreased is indicated, so that the process proceeds to step ST5 in FIG. 6 again and the above-described processes are executed.

On the other hand, when the current value determination unit 132 determines that the difference between the measured discharge current value and the previously measured discharge current value is within the range of the absolute value I2 (YES in ST4), the measured discharge current value indicates a constant value. The explanatory diagram of FIG. 4 illustrates a time point when the lead-acid battery B transitions from the charging process to the discharging process, then the state where the increased discharge current value stops increasing, and transitions to a state indicating a constant value.

The current value determination unit 132 transmits, for example, the determination result to the calculation unit 133, and the calculation unit 133 ascertains the discharge current value at this time point (ST11). Then, temperature correction process to the discharge current value is executed via the temperature correction unit 134 (ST12), and the discharge current value is integrated (ST13). Each processing is executed as long as the discharge current value measured by the current value determination unit 132 is determined to indicate a constant value.

In a case where the current value determination unit 132 determines that the difference between the measured discharge current value and the previously measured discharge current value deviates from the constant value while determining whether the repeatedly measured discharge current value is the constant value (NO in ST4), next, it is confirmed whether the determination corresponds to the determination at the time point at which the discharge current value increases or decreases from the constant value (ST5 in FIG. 6).

Here, a case where the discharge current value indicates a constant value after increasing and turns to increase again will be described as an example. It is, in the explanatory diagram of FIG. 4, the time point indicated by a reference sign c, that is, the time point when the discharge current value shifts from the state in which the discharge current value indicates a constant value to the state in which the discharge current value increases again.

This means that, after the current value determination unit 132 determines that the measured discharge current value is a constant value, a discharge current value deviating from the absolute value I2 is measured, and since the current discharge current value indicates a value larger than the previously measured discharge current value, the state has shifted to a state where the discharge current value has increased. Therefore, the determination by the current value determination unit 132 at this time point corresponds to the determination at the time point when the discharge current value starts increasing from a constant value (YES in ST5).

Therefore, the current value determination unit 132 divides the time to the time point indicated by the reference sign c as one section (in FIG. 4, the time to this point is indicated as "section 1"), and transmits a signal indicating this to the calculation unit 133. Then, the calculation unit 133 that has received the signal starts the CT value calculation process in the section 1.

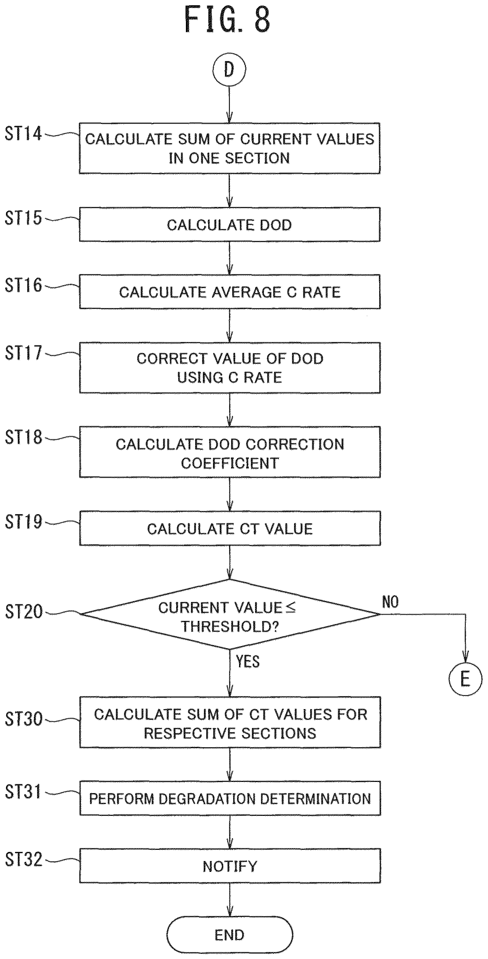

That is, first, the calculation unit 133 calculates the sum of the discharge current values in one section (here, section 1) (ST14 in FIG. 8). Then, the depth of discharge is calculated (ST15). In FIG. 8, the depth of discharge is represented as "DOD".

The calculation unit 133 further calculates the average C rate (ST16), and corrects the value of the depth of discharge using the calculated average C rate (ST17). The value of the depth of discharge (the value of the corrected depth of discharge) to be used for the CT value calculation process is calculated by the correction (ST18). The calculation unit 133 calculates the CT value using the above-described Equation 1 (ST19).

At this point, the CT value calculation process by the calculation unit 133 in one section is ended. The transition determination unit 131 determines whether or not the lead-acid battery B has transitioned from the discharging process to the charging process, that is, whether or not the measured discharge current value is equal to or less than the threshold I1 (ST20).

If the transition determination unit 131 determines that the measured discharge current value is a value larger than the threshold I1 (NO in ST20), the process returns to step ST3 in FIG. 5. Then, it is determined again whether the discharge current value is smaller than the threshold I1.

In describing the flow of the processing of the state determination unit 13, the section 1 illustrated in the explanatory diagram of FIG. 4 has been described as an example. The subsequent section 2 is also the same as the section 1 in that the change in the discharge current value becomes a constant value after the discharge current value increases. On the other hand, the section 3 is different from the processing described so far in that the discharge current value decreases at the start of the section 3 indicated by a reference sign d in FIG. 4 and then becomes a constant value. Therefore, next, a flow of processing of the state determination unit 13 in a case where the discharge current value decreases and then becomes a constant value will be described using the section 3 as an example.

First, the current value determination unit 132 determines whether the discharge current value includes a constant value, that is, the difference between the currently measured discharge current value and the previously measured discharge current value is included between the absolute values I2 (ST4), and further determines whether the determination is processing performed after the determination as to whether the discharge current value indicates a constant value (ST5) as described above.

The determination of the current value determination unit 132 illustrated in step ST5 is a determination at the time point of transition from the section 2 to the section 3 indicated by the reference sign d in the explanatory diagram of FIG. 4. That is, in step ST5, when the current value determination unit 132 determines that the determination that the discharge current value is included in the constant value is the processing performed after the determination as to whether or not the discharge current value indicates the constant value (YES in ST5), the calculation unit 133 executes the CT value calculation process in the section 2 as described above.

At the same time, since the section 2 ends and the section 3 starts, it is necessary to continuously execute each processing such as measurement of the discharge current value. Also in this case, the current value determination unit 132 determines whether the currently measured discharge current value is smaller than the previously measured discharge current value (ST6). In the section 3 starting from the time indicated by the reference sign d in FIG. 4, the discharge current value turns from a constant value to a decrease. Therefore, it is determined that the currently measured discharge current value is smaller than the previously measured discharge current value (YES in ST6).

When the discharge current value is decreasing as described above, first, it is determined whether the discharge current value measured by the current value determination unit 132 is smaller than the threshold I1 (ST21). If it is determined that the measured discharge current value is smaller than the threshold I1 (YES in ST21), processing described below is executed.

On the other hand, when the measured discharge current value is not smaller than the threshold I1 (NO in ST21), the temperature correction unit 134 performs temperature correction on the discharge current value measured by the assembled battery sensor 4 (ST22). Then, the discharge current value subjected to the temperature correction process is integrated and recorded in the recording unit 12 (ST23). That is, every time the discharge current value is measured in the assembled battery sensor 4, temperature correction is performed, and the corrected discharge current value is integrated.

After the discharge current value and the temperature are measured again (ST24), the current value determination unit 132 again determines whether the currently measured discharge current value is smaller than the previously measured discharge current value (ST25).

If the current value determination unit 132 determines that the discharge current value has decreased (YES in ST25), the process returns to step ST22. Subsequently, the respective processes of the temperature correction process, the integration process, the discharge current value, and the temperature measurement process of the measured discharge current value are executed.

On the other hand, when the previous discharge current value is subtracted from the current discharge current value and the value is less than 0 (NO in ST25), the process returns to step ST4 illustrated in FIG. 5. Then, the current value determination unit 132 determines again whether the difference between the currently measured discharge current value and the previously measured discharge current value is a value smaller than the absolute value I2. Thereafter, the processes executed by the current value determination unit 132 (ST11 to ST13) and the processes executed by the calculation unit 133 (ST14 to ST19), such as the determination as to whether the discharge current value is a constant value, are as described above.

The flow of the processing in the case where the discharge current value decreases as described above has been described with the section 3 as an example, but the same applies to the section 4. As a result of the determination of the change in the discharge current value by the current value determination unit 132, the section 3 is divided into one section at the time point indicated by a reference sign e in the explanatory diagram of FIG. 4, and the section 3 is newly switched to the section 4.

As illustrated in FIG. 4, in the section 4, there is no portion where the discharge current value indicates a constant value, and the lead-acid battery B transitions from the discharging process to the charging process while the discharge current value decreases. Therefore, the processing executed in steps ST11 to ST13 is omitted, and the process proceeds to the CT value calculation process by the calculation unit 133 through the determination related to the threshold I1 by the transition determination unit 131 described below.

In this way, the determination of the change in the discharge current value is executed by the current value determination unit 132, a plurality of sections are set in the discharge period, and the CT value is calculated for each section by the calculation unit 133.

Then, as described above, the transition determination unit 131 again determines whether the discharge current value is equal to or less than the threshold (ST20). Here, the determination by the transition determination unit 131 is determination of whether or not the lead-acid battery B has transitioned from the discharging process to the charging process. If the transition determination unit 131 determines that the discharging process is being continued (NO in ST20), the process returns to step ST3, and the processes described above are executed.

On the other hand, in a case where the transition determination unit 131 determines that the transition to the charge state has occurred (YES in ST20), the calculation unit 133 adds the CT values for the respective sections calculated so far for the respective sections to calculate the sum (ST30). The CT value as the sum is the CT value in the discharge period.

The calculated CT value is transmitted from the calculation unit 133 to the degradation determination unit 135, and the degradation determination unit 135 performs the latest degradation determination on the lead-acid battery B (ST31). Then, the determination result is displayed on, for example, the display unit via the output unit 136 and notified to the operator of the lead-acid battery system S (ST32). Here, the degradation determination process in the discharge period of the lead-acid battery B is completed.

The degradation determination process of the lead-acid battery B is executed in the flow described above, but the processing is based on the premise that the discharging process is performed in the lead-acid battery B. Therefore, for example, during the transition from the charging process to the discharging process or the transition from the discharging process to the charging process, although the discharging process is continued, there occurs a portion where it is necessary to determine whether or not the process for ascertaining the current amount may be continuously executed.

Therefore, for example, in the explanatory diagram of FIG. 4, when the lead-acid battery B denoted by the reference sign a transitions from the charging process to the discharging process, the transition determination unit 131 determines whether or not the discharge current value is a value smaller than the threshold I1 (ST3).

When the discharging process is continuing and the current value determination unit 132 determines that the discharge current value is decreasing (ST6), the transition determination unit 131 determines that a determination is made as to whether the discharge current value is smaller than the threshold I1 (ST21). As a result, when the discharge current value is smaller than the threshold I1, the following processing is executed.

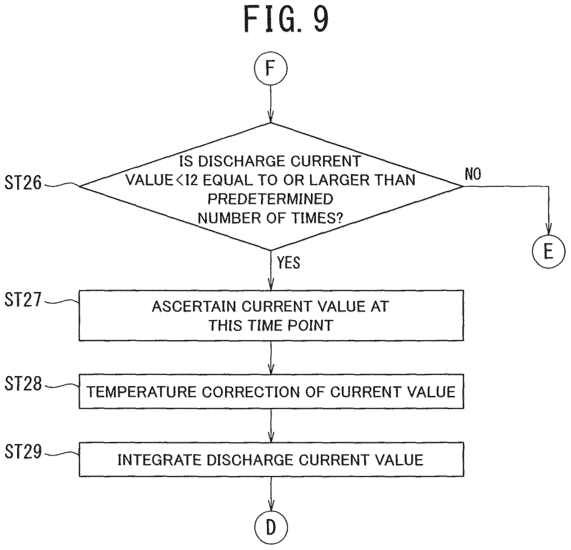

That is, when the transition determination unit 131 determines that the discharge current value is smaller than the threshold I1 (YES in ST3, YES in ST21), the process proceeds to step ST26 in FIG. 9. Then, the transition determination unit 131 determines whether the discharge current value being smaller than the threshold I1 has been continuously measured a predetermined number of times or more.

The reason why such a determination is required is that even if the discharge current value shows a value smaller than the threshold I1 once, if it can be determined that the discharging process is continuously executed thereafter, the degradation determination process of the lead-acid battery B as described above can be executed. Note that the "predetermined number of times" used as the determination criterion here is a value set in advance in the setting unit 14, and can be arbitrarily set.

Therefore, when the transition determination unit 131 determines that the number of times that discharge current value is smaller than the threshold I1 is not equal to or larger than a predetermined number of times (NO in ST26), the process returns again to the determination process as to whether the discharge current value is smaller than the threshold I1 in step ST3.

On the other hand, when the transition determination unit 131 determines that the number of times that discharge current value is smaller than the threshold I1 is a predetermined number of times or more (YES in ST26), it is determined that the discharging process is not to be continuously performed in the future. Therefore, the discharge current value at this time point is ascertained (ST27), and after temperature correction by the temperature correction unit 134 (ST28), integration process of the discharge current value is executed (ST29).

Then, the process proceeds to the CT value calculation process by the calculation unit 133 using the integrated discharge current value, and the above-described process is executed (ST14 and subsequent stages in FIG. 8).

As described above, in the lead-acid battery system S according to the embodiment of the present invention, the CT value is used in executing the degradation determination process of the lead-acid battery B. In the CT value calculation process, the discharge current amount during the discharging process of the lead-acid battery B is used.

By performing such processing, more accurate degradation determination process of the lead-acid battery using the CT value that is not affected by the cause of degradation of the lead-acid battery B can be executed. This leads to more accurate estimation of the degradation degree of the lead-acid battery, so that it is possible to provide a lead-acid battery system and a lead-acid battery life estimation method capable of contributing to further improvement of reliability.

In particular, by executing the process of measuring and integrating the discharge current amount in the discharge period for each section obtained by dividing the discharge period by the time point at which the discharge current value changes, it is possible to more accurately integrate the discharge current value. Then, the CT for each section is calculated using the information obtained by these processes, the sum of the CT values in the discharge period is calculated, and the degradation degree of the lead-acid battery is estimated using the sum of the CT values. By executing such process, it is possible to finally estimate the degradation degree with higher accuracy.

Note that the flow of the CT value calculation process by the calculation unit 133 may be a flow described below in addition to the above-described flow. That is, the correction process based on the temperature of the discharge current value measured in the assembled battery sensor 4 can be executed not at the timing as described above but at another timing.

In the CT value calculation process in the above description, for example, as illustrated in step ST12 of FIG. 5, the temperature correction of the measured discharge current value is executed every time the discharge current value is measured.

However, instead of the temperature correction process at this timing, the temperature correction process can be collectively executed on the integrated discharge current value using Equation 2 as described above. Therefore, after the transition determination unit 131 determines whether the discharge current value is smaller than the threshold I1 and after the current value determination unit 132 determines that the discharge current value increases, exhibits a phenomenon, or exhibits a constant value, the temperature correction process is not performed, and the discharge current value integration process is performed immediately.

This also applies to a case where the transition determination unit 131 determines whether or not a state in which the discharge current value is smaller than the threshold I1 appears a predetermined number of times or more, and the discharge current value at this time point is ascertained as being equal to or larger than the predetermined number of times. The temperature correction process to the discharge current value ascertained here is not executed, and the process proceeds to the CT value calculation process.

Here, the temperature correction process is executed by the temperature correction unit 134 after step ST15 (see FIG. 8) in which the value of the depth of discharge or the like is actually calculated by the calculation unit 133. Specifically, the processing is executed after the value of the depth of discharge is corrected by the C rate and a correction coefficient related to the depth of discharge is calculated and before the CT value is calculated. When the CT value is calculated by the calculation unit 133, the above-described Equation 2 is used.

As described above, the timing of the temperature correction process for the discharge current value can be performed immediately before the CT value is calculated. Therefore, more accurate degradation determination process of the lead-acid battery using the CT value that is not affected by the cause of degradation of the lead-acid battery B can be executed. This leads to more accurate estimation of the degradation degree of the lead-acid battery, so that it is possible to provide a lead-acid battery system and a lead-acid battery life estimation method capable of contributing to further improvement of reliability.

The process of measuring and integrating the discharge current amount in the discharge period is not different in that the discharge period is executed for each section obtained by dividing the discharge period based on the time point at which the plurality of discharge current values change. Therefore, the discharge current value can be integrated more accurately, and the degradation degree of the lead-acid battery can be estimated with higher accuracy in the end.

### (Second Embodiment)

Next, a second embodiment in the present invention is described. In the second embodiment, the same constituent elements as those described in the above first embodiment are denoted by the same reference signs, and a description of the same constituent elements is omitted because of redundancy.

A lead-acid battery system S according to the second embodiment of the present invention is the same as the lead-acid battery system S according to the first embodiment described above in that a section is divided at a time point when a change occurs in a discharge current value in a discharge period, and a discharge current value (discharge capacity) in the section is ascertained. However, a manner of calculating the discharge capacity in each of the divided sections and a manner of calculating the CT value using the calculated discharge capacity are different.

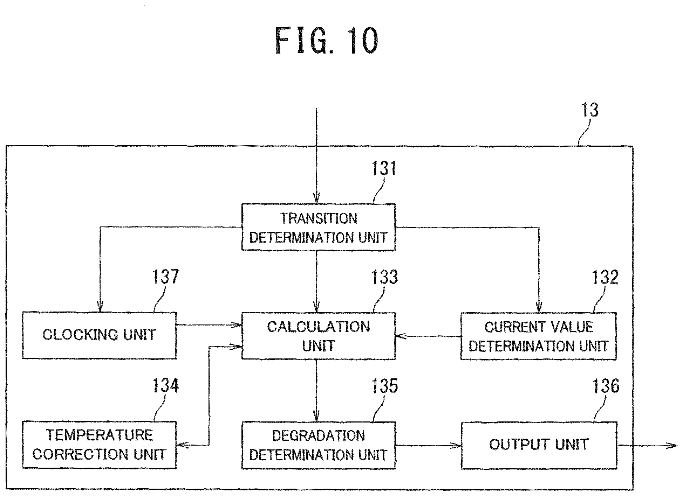

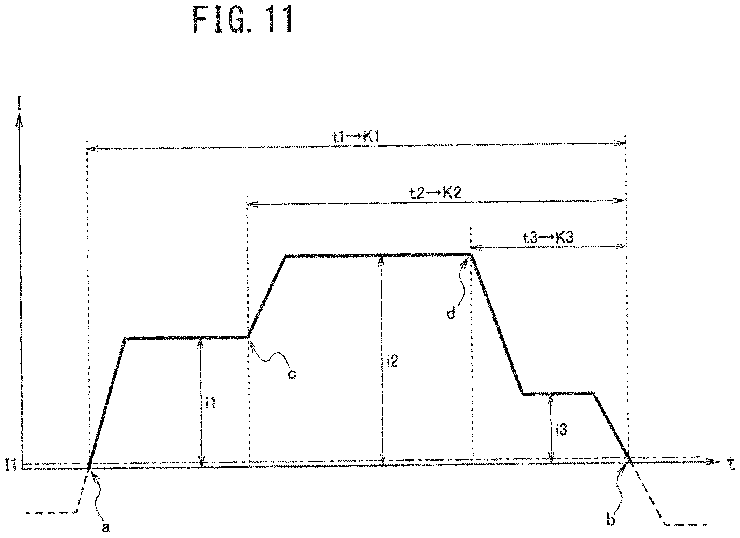

Hereinafter, this point will be sequentially described with reference to FIG. 10 and subsequent drawings. FIG. 10 is a block diagram illustrating a detailed internal configuration of the state determination unit 13 according to the second embodiment of the present invention. FIG. 11 is an explanatory view illustrating a time course of charging/discharging process of the lead-acid battery B in the second embodiment of the present invention.

As illustrated in FIG. 10, the state determination unit 13 in the second embodiment includes a clocking unit 137 in addition to the configuration described above. The clocking unit 137 executes processing of measuring the time until the lead-acid battery B transitions from the discharging process to the charging process each time the current value determination unit 132 determines that a change in the discharge current value has occurred in the discharge period, the section is divided, and a new section is started.

This will be described with reference to FIG. 11. At the time point when the lead-acid battery B transitions from the charging process to the discharging process, which is denoted by a reference sign a in FIG. 11, the clocking unit 137 starts the measurement process of the integration time. Then, the measurement process of the integration time is continued until the transition from the discharging process indicated by the lead-acid battery b and indicated by a reference sign b to the charging process is performed. The integration time measured during this time is represented as "t1" in FIG. 11.

Next, the section is divided at a time point indicated by a reference sign c in FIG. 11 at which the current value determination unit 132 determines that a change has occurred in the discharge current value, and a new section is started from this time point. Therefore, from this time point, the clocking unit 137 starts the integration time measurement process. As described above, an end point of the measurement process by the clocking unit 137 is from the discharging process indicated by the lead-acid battery b to the charging process. The integration time measured during this period is represented as "t2" in FIG. 11.

Furthermore, the clocking unit 137 divides the section at the time point indicated by a reference sign d in FIG. 11 at which the current value determination unit 132 determines that a change has occurred in the discharge current value, and starts the integration time measurement process from the time point. As described above, an end point of the measurement process by the clocking unit 137 is from the discharging process indicated by the lead-acid battery b to the charging process. The integration time measured during this period is represented as "t3" in FIG. 11.

As described above, the clocking unit 137 according to the second embodiment of the present invention measures the integration time of t1 to t3 for each section. Then, the integration time of t1 to t3 measured for each of these sections is converted into capacity conversion times K1 to K3.

Here, the capacity conversion time K is a time calculated by applying the integration time to the relationship indicated by the non-linear graph. As described below, the calculation unit 133 calculates the discharge current value using the capacity conversion time K converted from the integration time measured by the clocking unit 137.

When the clocking unit 137 calculates the capacity conversion time K, the measured integration time is applied to, for example, a conversion table stored in the clocking unit 137. Alternatively, the calculation may be performed using a conversion equation. In addition, although the storage location of the conversion table and the like is in the clocking unit 137 here, for example, the conversion table and the like may be stored in the recording unit 12 of the BMU 1 and the calculation process may be executed by being accessed by the clocking unit 137.

The calculation process of the integration time into the capacity conversion time K by the clocking unit 137 is illustrated in FIG. 11 by outputting an arrow from the integration time t1 to K1, for example.

Next, the CT value calculation process by the calculation unit 133 will be described. In the first embodiment of the present invention described above, the CT value calculation process is executed for each section, and the degradation determination process of the lead-acid battery B is executed by the degradation determination unit 135 based on the sum of the plurality of CT values finally calculated for each section.

On the other hand, the calculation unit 133 in the second embodiment collectively executes the CT value calculation process after the lead-acid battery B transitions from the discharging process to the charging process and the discharge period ends. At that time, the capacity conversion time K calculated by the clocking unit 137 is used. Specifically, it is described as follows.

That is, the integration time measurement process by the clocking unit 137 is started, and the current value determination unit 132 determines whether the discharge current value has changed. As described above, the current value determination unit 132 determines whether or not the discharge current value increases, decreases, or indicates a constant value. Here, in particular, the discharge current value in a case where the discharge current value indicates a constant value is ascertained. As described in the first embodiment, the term "constant value" used herein means a difference between a currently measured discharge current value and a previously measured discharge current value, which has a certain range and includes absolute value I2.

This will be described with reference to the explanatory diagram of FIG. 11. The section in which it is determined by the current value determination unit 132 that a change in the discharge current value has occurred and set includes a state in which the discharge current value increases or decreases and a state in which the discharge current value indicates a constant value. Therefore, for example, in a section in which the measurement process of the integration time t1 is executed by the clocking unit 137, the discharge current value indicated by "i1" is ascertained as the discharge current value in the section.

Similarly, in a section in which the measurement process of the integration time t2 is executed by the clocking unit 137, the discharge current value indicated by "12" is ascertained as the discharge current value in the section. In a section in which the measurement process of the integration time t3 is executed by the clocking unit 137, the discharge current value indicated by "13" is ascertained as the discharge current value in the section.

The measurement process of the integration time t by the clocking unit 137 ends when the lead-acid battery B transitions from the discharging process to the charging process and the discharge period ends. The clocking unit 137 ascertains each measured integration time t, and calculates the capacity conversion time K by converting each integration time t using, for example, the conversion table described above.

The calculation unit 133 calculates the discharge capacity for each integration time by multiplying the calculated capacity conversion time K by the discharge current value ascertained in each section. That is, since the discharge capacity for each section is obtained by the processing, the sum of these discharge capacities is calculated as the total discharge capacity in the discharge period.

Since the total discharge capacity in the discharge period is calculated by executing such processing by the calculation unit 133, the CT value calculation process is executed using this value. However, it may be necessary to consider the calculated total discharge capacity.

That is, the lead-acid battery system S is required to more reliably ascertain the degradation degree of the lead-acid battery B. Therefore, when the value of the CT value to be calculated is large or small, it is safer to adopt a larger value as the CT value and estimate the CT value to be large.

From such a viewpoint, when the total discharge capacity is calculated by adding the discharge capacities for the respective sections, it is desired to avoid a decrease in the total discharge capacity during the discharge period. This will be described below with reference to the explanatory diagram of FIG. 11.

The section divided by the integration time t3 in FIG. 11 is a section in which the discharge current value decreases, unlike the sections divided by the integration times t1 and t2. Therefore, depending on a converted value, the discharge capacity in the section divided by the integration time t3 may become negative as a result.

Therefore, the value obtained by adding all the discharge current values in the section divided by the integration time t1 to the integration time t3 may be smaller than the value obtained by adding the discharge current values in the section divided by the integration time t1 and the integration time t2.

In this case, the CT value calculation process from the viewpoint as described above is not appropriate. Therefore, for a section in which the discharge current value decreases, it is determined whether or not the discharge capacity calculated from the section is included in the total discharge capacity. That is, the value of the total discharge capacity in the case where the discharge capacity calculated from the section is included in the total discharge capacity is compared with the value of the total discharge capacity in the case where the discharge capacity is not included in the total discharge capacity, and the larger discharge capacity is selected.

Therefore, when calculating the total discharge capacity, which is the sum of the discharge capacities calculated in the respective sections, the calculation unit 133 executes processing of comparing a case where the discharge capacity in the section where the discharge current value is negative is included with a case where the discharge capacity in the section where the discharge current value is negative is not included. As a result of the comparison process, a value when any larger discharge capacity is obtained is selected as the total discharge capacity.

After the total discharge capacity is calculated, the CT value calculation process described in the first embodiment is executed. By executing such processing, the CT value to be calculated can be estimated to be larger, and a CT value effective for determining the degradation degree of the lead-acid battery B can be obtained.

### [Operation]

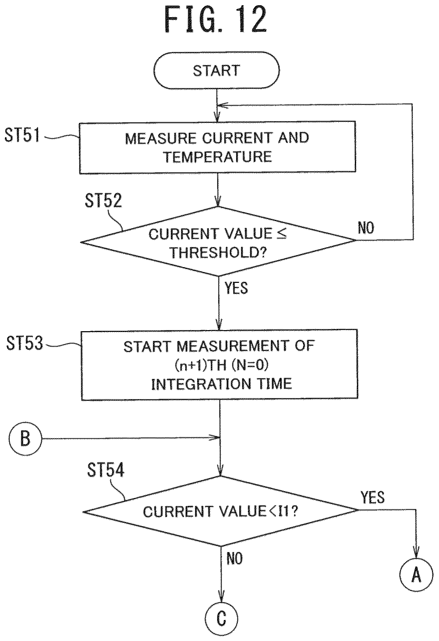

Next, a flow in which the BMU 1 determines the degradation degree of the lead-acid battery B will be described with reference to FIGS. 12 to 18. FIGS. 12 to 18 are flowcharts illustrating a flow of determining the degradation degree of the lead-acid battery B using the lead-acid battery system S according to the second embodiment of the present invention.

First, the current value of the lead-acid battery B is measured by the assembled battery sensor 4, and the temperature of the lead-acid battery B is measured by the temperature sensor TS provided in the lead-acid battery B (ST51). Information regarding the current value and the temperature measured by each sensor is transmitted to the BMU 1 and recorded in the recording unit 12 via the sensing input unit 11.

Then, the transition determination unit 131 constituting the state determination unit 13 determines whether or not the lead-acid battery B has transitioned from the charging process to the discharging process, that is, whether or not the current value measured in the assembled battery sensor 4 is equal to or less than the threshold (ST52).

If the value of the current value is larger than the threshold (NO in ST52), it is determined that the charging process is continuously executed in the lead-acid battery B, and the process returns to step ST51 to continue the measurement of the current value and the temperature.

When it is determined that the current value measured by the transition determination unit 131 is equal to or less than the threshold (YES in ST52), it is determined that the lead-acid battery B has transitioned from the charging process to the discharging process. Then, with this determination as a trigger, the clocking unit 137 starts measuring of (n+1)th (n=0) integration time (ST53). That is, it is a time point indicated by the reference sign a in the explanatory diagram of FIG. 11.

Further, in order to determine whether or not to continuously execute the process of ascertaining the current value, the transition determination unit 131 determines whether or not the discharge current value is a value smaller than the threshold I1 (ST54).

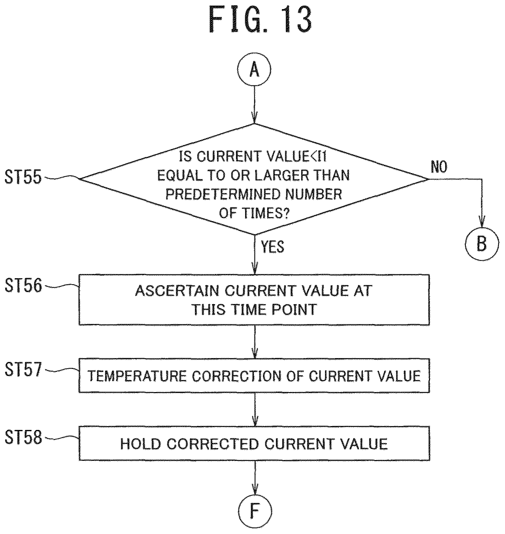

First, if the transition determination unit 131 determines that the discharge current value is smaller than the threshold I1 (YES in ST54), the process proceeds to step ST55 in FIG. 13. Then, the transition determination unit 131 determines whether the discharge current value being smaller than the threshold I1 has been continuously measured a predetermined number of times or more.

The reason why such a determination is required is that even if the discharge current value shows a value smaller than the threshold I1 once, if it can be determined that the discharging process is continuously executed thereafter, the degradation determination process of the lead-acid battery B as described above can be executed. Note that the "predetermined number of times" can be arbitrarily set in the setting unit 14 in advance as described above.

Therefore, when the transition determination unit 131 determines that the value at which the discharge current value is smaller than the threshold I1 is not equal to or larger than the predetermined number of times (NO in ST55), the process returns again to the determination process of determining whether the discharge current value is smaller than the threshold I1 in step ST54.

On the other hand, when the transition determination unit 131 determines that the discharge current value is smaller than the threshold I1 the predetermined number of times or more (YES in ST55), it is determined that the discharging process is not to be continuously performed in the future. Therefore, the discharge current value at this time point is ascertained (ST56), and after temperature correction by the temperature correction unit 134 (ST57), the corrected discharge current value is held (ST58).

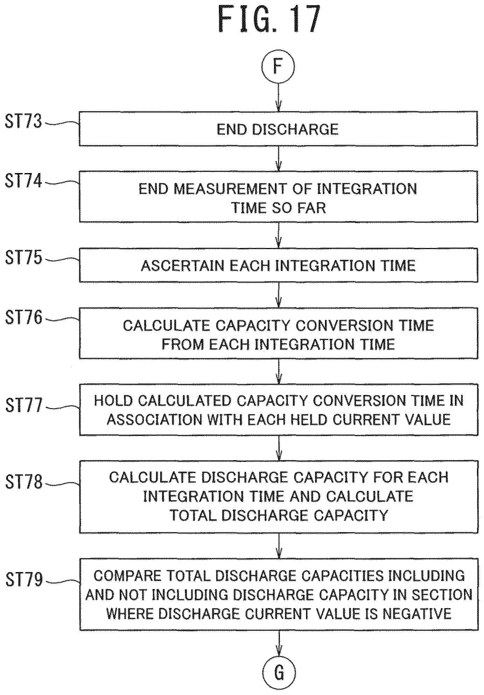

Then, a process of converting the integration time t into the capacity conversion time K by the clocking unit 137 as described below is executed. The CT value calculation process is executed through the calculation process of the total discharge capacity using the discharge current value by the calculation unit 133 (ST73 in FIG. 17 and below).

On the other hand, when it is determined by the transition determination unit 131 that the discharge current value is not smaller than the threshold I1 (NO in ST54), the discharging process is continuously executed. Therefore, processing necessary for determining the degradation degree of the lead-acid battery B is started from here.

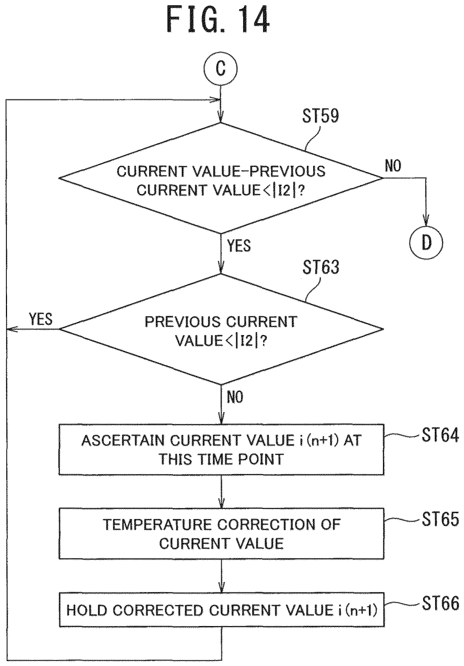

That is, first, the current value determination unit 132 determines whether or not there is a change in the measured discharge current value (ST59 in FIG. 14). Specifically, it is determined whether the discharge current value indicates a constant value, that is, the currently measured discharge current value and the previously measured discharge current value are the same value.

As described above, the constant value also includes the discharge current value I2 having a preset plus or minus value. Therefore, as illustrated in step ST59 of FIG. 14, the current value determination unit 132 determines whether the difference between the measured discharge current value and the previously measured discharge current value is smaller than the absolute value 12.

When the difference between the currently measured discharge current value and the previously measured discharge current value is not a value smaller than the absolute value I2 (NO in ST59), it indicates that the currently measured discharge current value does not indicates a constant value but increases or decreases.

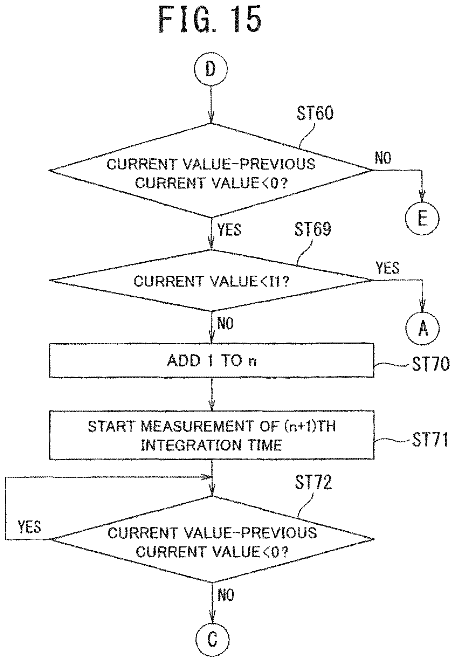

Then, the current value determination unit 132 determines whether the currently measured discharge current value is smaller than the previously measured discharge current value (ST60 in FIG. 15). This determination makes it clear whether the state of the measured discharge current value tends to increase or decrease. Here, first, a case where the discharge current value increases will be described.

That is, in the explanatory diagram of FIG. 11, this state is a state in which the lead-acid battery B has transitioned from the charging process to the discharging process, and the value of the discharge current value has increased, but has not yet reached a constant value.

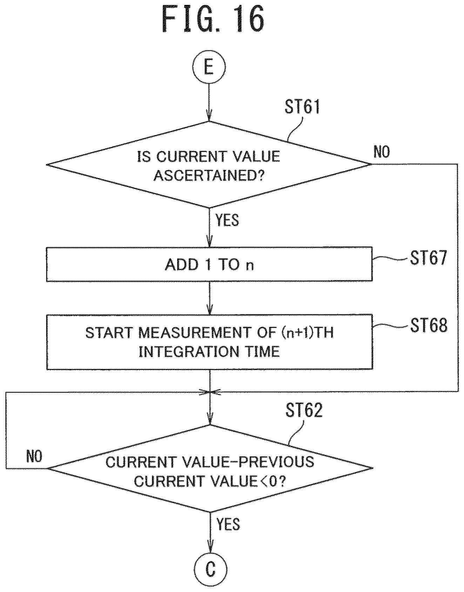

In a case where it is determined by the current value determination unit 132 that the discharge current value measured by the current value determination unit 132 has increased (NO in ST60), it is determined by the current value determination unit 132 whether or not the discharge current value is ascertained (ST61 in FIG. 16). Here, as described above, although the value of the discharge current value is increased, the discharge current value is not yet constant (NO in ST61), so the discharge current value is not ascertained.

Therefore, the current value determination unit 132 determines again whether the currently measured discharge current value is smaller than the previously measured discharge current value (ST62). When the discharge current value is increasing, the currently measured discharge current value is larger than the previously measured discharge current value (NO in ST62), and thus the determination process by the current value determination unit 132 is continued.

Such determination process by the current value determination unit 132 is executed, and for example, the increased discharge current value indicates a constant value from a certain time point. The explanatory diagram of FIG. 11 illustrates a time point when the lead-acid battery B transitions from the charging process to the discharging process, then the state in which the increased discharge current value stops increasing, and transitions to a state indicating a constant value.

Therefore, when the current value determination unit 132 determines that the currently measured discharge current value is smaller than the previously measured discharge current value (YES in ST62), the process returns to step ST59 again. Then, it is determined whether the measured discharge current value indicates a constant value.

Here, the current value determination unit 132 determines that the discharge current value indicates a constant value (YES in ST59). Therefore, it is further determined whether it was ascertained that the previously measured discharge current value has already indicated a constant value (ST63).

When the increased discharge current value stops increasing and shifts to a state illustrating a constant value, the previously measured discharge current value does not indicate a constant value (NO in ST63). Therefore, in this case, the current value determination unit 132 ascertains the discharge current value i(n+1) at this time point (ST64).

Since the discharge current value i(n+1) ascertained by the current value determination unit 132 is n=0 as illustrated in step ST53, the discharge current value ascertained here is i1. FIG. 11 illustrates a discharge current value i1 as a value at which the discharge current value indicates a constant value for the first time after the lead-acid battery B shifts from the charging process to the discharging process.

Then, the temperature correction unit 134 performs temperature correction process on the ascertained discharge current value i(n+1) (ST65). The corrected discharge current value i(n+1) is held in the calculation unit 133, for example (ST66).

The place where the discharge current value i(n+1) is held (stored) is the calculation unit 133 here, but may be held in the recording unit 12, for example.

In the processing so far, the discharge current value continues to indicate a constant value. Therefore, after the corrected discharge current value i(n+1) is held, the processing of steps ST59 and ST63 is repeatedly executed until the current value determination unit 132 determines that a change has occurred in the discharge current value.

When the current value determination unit 132 determines that the discharge current value does not indicate a constant value again (NO in ST59), the discharge current value increases or decreases. Here, a case where the discharge current value increases will be described again as an example.

That is, when the current value determination unit 132 determines that the discharge current value increases (NO in ST60), the calculation unit 133 determines whether the discharge current value is ascertained (ST61). As described above, in the above description, the current value determination unit 132 determines that the discharge current value indicates a constant value, and the calculation unit 133 ascertains the discharge current value i1 on the basis of the determination (ST64 to ST66).

Therefore, since the calculation unit 133 has already ascertained the discharge current value, when the current value determination unit 132 determines that the discharge current value has increased, it can be determined that a change has occurred in the discharge current value.

Therefore, the clocking unit 137 starts measurement process of a new integration time on the assumption that a new section is started from this time point. That is, 1 is first added to n (ST67), and the measurement process of the integration time in the (n+1)th section is started (ST68). As illustrated in FIG. 11, the clocking process of the integration time t2 by the clocking unit 137 is started from here.

Then, the current value determination unit 132 determines whether or not the discharge current value has increased (ST62), and if the increase has changed to a constant value, determines whether or not the discharge current value indicates a constant value (ST59). In a case where a constant value is indicated, the processing of steps ST63 to ST66 described above is executed.

The case where the discharge current value increases has been described above. On the other hand, the discharge current value may decrease during the discharge period. Therefore, next, processing in a case where the discharge current value decreases will be described.

As described above, the current value determination unit 132 determines whether the discharge current value indicates a constant value (ST59), and when it is determined that the discharge current value does not indicate a constant value (NO in ST59), it is determined whether the discharge current value is increasing or decreasing (ST60).

Here, the current value determination unit 132 determines that the discharge current value is decreasing (YES in ST60). Therefore, next, the transition determination unit 131 determines whether the discharge current value indicates a value smaller than the threshold I1 (ST65).

The determination process by the current value determination unit 132 and the transition determination unit 131 here is determination at the time point indicated by the reference sign d in FIG. 11. Since the lead-acid battery B does not yet transition from the discharging process to the charging process at the time point indicated by the reference sign d, the determination here means that the discharge current value does not indicate a value smaller than the threshold I1 (NO in ST65).

In addition, according to the determination by the current value determination unit 132, the state in which the discharge current value decreases is a state in which the discharge current value appears after indicating a constant value, and it can be determined that the discharge current value has changed. Therefore, the clocking unit 137 starts measurement process of a new integration time on the assumption that a new section is started from this time point.

That is, 1 is first added to n (ST70), and the measurement process of the integration time in the (n+1)th section is started (ST71). As illustrated in FIG. 11, the clocking process of the integration time t3 by the clocking unit 137 is started from here.

Then, the current value determination unit 132 further determines whether a value obtained by subtracting the previously measured discharge current value from the currently measured discharge current value is a value smaller than 0 (ST72). As a result, when the currently measured discharge current value is smaller than the previously measured discharge current value (YES in ST72), it can be determined that the discharge current value is in the decreasing state.

On the other hand, when the currently measured discharge current value is not smaller than the previously measured discharge current value (NO in ST72), the process returns to step ST59, and it is determined whether or not the measured discharge current value indicates a constant value.

Here, as described above, the discharge current value having a constant value is ascertained, the temperature correction process to the discharge current value is performed, and then the discharge current value is held (ST64 to ST66). The discharge current value held in this process is the discharge current value i3 illustrated in FIG. 11.

When the discharge current value decreases, it is conceivable that the discharge current value indicates a value smaller than the threshold I1 according to the determination by the transition determination unit 131 described above (YES in ST69). In this case, as described with reference to FIG. 13, it is determined whether the discharge current value indicates a value smaller than the threshold I1 a predetermined number of times or more (ST55).

If it is determined that the number of times is equal to or larger than the predetermined number of times (YES in ST55), the discharge current value at this time point is ascertained, the temperature correction process to the discharge current value is performed, and then processing of holding the discharge current value is executed (ST56 to ST58). At this time point, the lead-acid battery B transitions from the discharging process to the charging process, and thus, the CT value calculation process by the calculation unit 133 is executed from this time point.

As described above, the discharging process ends at this time point (ST73 in FIG. 17). Then, the measurement process of the integration time, which has been continuously executed so far, ends (ST74).

As is also clear from FIG. 11, in the second embodiment of the present invention, the number of sections in which it is determined and divided by the current value determination unit 132 that a change in the discharge current value has occurred is 3. The clocking unit 137 starts measurement process each time these three sections are started, and executes measurement process of three integration times in parallel. Here, all the measurement process ends.

The clocking unit 137 ascertains each integration time (ST75) and calculates a capacity conversion time from each integration time (ST76). That is, the integration time t1 illustrated in FIG. 11 is converted into the capacity conversion time K1, and similarly, the integration time t2 is converted into the capacity conversion time K2, and the integration time t3 is converted into the capacity conversion time K3.

By the processing by the clocking unit 137, three capacity conversion times K1 to K3 are calculated, and the discharge current value ascertained in each section is held in association with each of the capacity conversion times (ST77).

As a result, for example, the capacity conversion time K in each section and the corresponding discharge current value are associated, such as the capacity conversion time K1 and the discharge current value i1. Note that these pieces of information associated with each other may be held in any of the recording unit 12, the calculation unit 133, and the like, for example.

Then, the calculation unit 133 calculates the discharge capacity in the corresponding section using the associated capacity conversion time K and the corresponding discharge current value. When the discharge capacity in each section is calculated, the total discharge capacity is calculated by adding all the calculated discharge capacities (ST78).

Although the total discharge capacity necessary for the calculation unit 133 to calculate the CT value has been acquired so far, as described above, the presence of a section in which the discharge current value becomes negative during the discharge period affects the value of the total discharge capacity finally obtained.

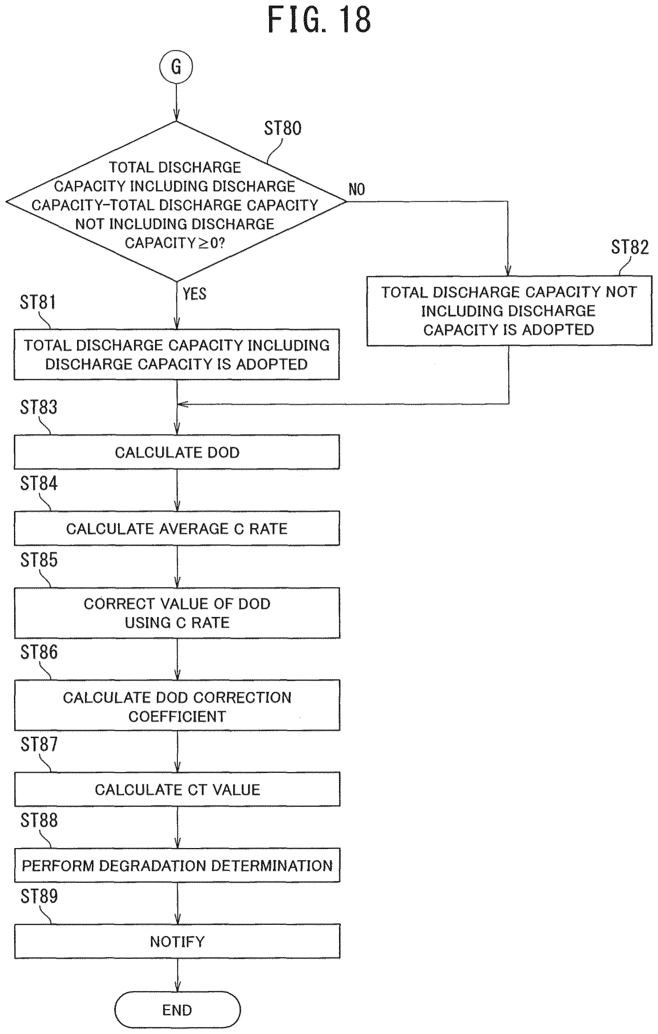

Therefore, the calculation unit 133 compares the respective total discharge capacities with and without the discharge capacity in the section where the discharge current value is negative (ST79). Then, it is determined whether or not the former has a value of 0 or more when the latter is subtracted from the former, that is, whether or not the former has a value larger than the latter (ST80 in FIG. 18).

As a result, when the discharge current value is included (the former has a larger value), the total discharge capacity including the discharge capacity in the section where the discharge current value is negative is adopted (ST81). On the other hand, when the discharge current value is not included (when the latter is larger), the total discharge capacity not including the discharge capacity in the section where the discharge current value is negative is adopted (ST82). By this process, a larger total discharge capacity can be adopted.

In this state, the calculation unit 133 first calculates the depth of discharge in order to calculate the CT value in the discharge section (ST83). Then, the calculation unit 133 further calculates the average C rate (ST84), and corrects the value of the depth of discharge using the calculated average C rate (ST85). The value of the depth of discharge (the value of the corrected depth of discharge) to be used for the CT value calculation process is calculated by the correction (ST86). The calculation unit 133 calculates the CT value using the above-described Equation 1 (ST87).

The calculated CT value is transmitted from the calculation unit 133 to the degradation determination unit 135, and the degradation determination unit 135 performs the latest degradation determination on the lead-acid battery B (ST88). Then, the determination result is displayed on, for example, the display unit via the output unit 136 and notified to the operator of the lead-acid battery system S (ST89). Here, the degradation determination process in the discharge period of the lead-acid battery B is completed.

As described above, in the lead-acid battery system S according to the embodiment of the present invention, the CT value is used in executing the degradation determination process of the lead-acid battery B. In the CT value calculation process, the discharge current amount during the discharging process of the lead-acid battery B is used.

By performing such processing, more accurate degradation determination process of the lead-acid battery using the CT value that is not affected by the cause of degradation of the lead-acid battery B can be executed. This leads to more accurate estimation of the degradation degree of the lead-acid battery, so that it is possible to provide a lead-acid battery system and a lead-acid battery life estimation method capable of contributing to further improvement of reliability.

In particular, the integration time measured by the clocking unit 137 is not directly used for the calculation of the discharge capacity, but is once converted from the integration time into the capacity conversion time and then used. In addition, with respect to the calculation of the total discharge capacity as a premise for calculating the CT value, the calculation unit 133 executes comparison process between the case of including the discharge capacity in the section where the discharge current value is negative and the case of not including the discharge capacity, adopts a larger total discharge capacity, and uses the total discharge capacity for the calculation of the CT value.

By executing such processing, it is possible to provide the operator of the lead-acid battery system S with information that can be ascertained as a state in which the degradation degree of the lead-acid battery B has further progressed, that is, a degradation degree slightly deteriorated from an accurate degradation degree at the present time. Therefore, the operator can quickly and accurately respond to the degradation of the lead-acid battery system S.

Note that, as illustrated in step ST57, step ST65, and the like, every time the discharge current value is ascertained, the temperature correction process by the temperature correction unit 134 has been executed on the ascertained discharge current value. However, the temperature correction process may not be executed at such timing.

That is, the capacity conversion time is calculated from each integration time by the clocking unit 137, and the capacity conversion time and the held discharge current value are associated with each other. Alternatively, temperature correction process to the ascertained discharge current value may be executed during these processes or at the end of discharge. In this case, the calculation unit 133 calculates the CT value using Equation 2 described in the first embodiment.

The technology described in the embodiment of the present invention can adopt the following configuration.
(1) A lead-acid battery system including:
   a transition determination unit configured to determine switching of charging/discharging process of a lead-acid battery;
   a current value determination unit configured to detect a change in a discharge current value during a discharge period of the lead-acid battery;
   a calculation unit configured to, when the current value determination unit determines that a change has occurred in the discharge current value, calculate a CT value based on the discharge current value acquired for each section divided by the occurrence of the change; and
   a degradation determination unit configured to determine a degradation degree of the lead-acid battery using the CT value calculated by the calculation unit.
(2) The lead-acid battery system according to (1), wherein, when a section in which the discharge current value changes and a section in which the discharge current value does not change are collectively defined as one section, the current value determination unit determines that a change has occurred in the discharge current value at a time point at which a section in which the discharge current value does not change is shifted again to a section in which the discharge current value changes.
(3) The lead-acid battery system according to (1) or (2), wherein the calculation unit calculates a CT value for each of a plurality of sections, and calculates a sum of the calculated CT values as the CT value in the discharge period.
(4) The lead-acid battery system according to (1), further including a clocking unit configured to measure an elapse of an integration time in the discharge period.
(5) The lead-acid battery system according to (4), wherein when a section in which the discharge current value changes and a section in which the discharge current value does not change are collectively defined as one section, the clocking unit starts measuring of the integration time at a time point at which the section in which the discharge current value changes in the one section starts.
(6) The lead-acid battery system according to (4) or (5), wherein the clocking unit ends the measurement of the integration time when the transition determination unit determines that the lead-acid battery has transitioned from the discharge period to a charge period.
(7) The lead-acid battery system according to any one of (4) to (6), wherein the clocking unit ascertains each of the measured integration times, and calculates a capacity conversion time for each of the ascertained integration times.
(8) The lead-acid battery system according to any one of (5) to (7), wherein the current value determination unit ascertains the discharge current value in a section in which the discharge current value does not change in the one section.
(9) The lead-acid battery system according to any one of (4) to (8), wherein the calculation unit starts a calculation process of the CT value when the transition determination unit determines that the discharge period ends after the lead-acid battery transitions from the discharge period to the charge period.
(10) The lead-acid battery system according to any one of (4) to (9), wherein the calculation unit calculates the discharge capacity for each section by multiplying the capacity conversion time calculated by the clocking unit by the discharge current value that is ascertained, and calculates a sum of the calculated discharge capacities for each integration time as a total discharge capacity.
(11) The lead-acid battery system according to (10), wherein when the discharge capacity calculated for each section indicates a negative value, the calculation unit compares a case where the discharge capacity is included in the total discharge capacity with a case where the discharge capacity is not included in the total discharge capacity, and selects a case where the discharge capacity shows a larger value of the total discharge capacity as the total discharge capacity.
(12) A lead-acid battery life estimation method, including:
   determining whether or not a lead-acid battery is switched from a charging process to a discharging process;
   measuring a current in the discharging process when it is determined that the lead-acid battery is switched to the discharging process;
   integrating measured discharge current values;
   determining whether the discharge current value has changed;
   executing a calculation process of a CT value using the integrated discharge current value when it is determined that the discharge current value has changed;
   determining whether the lead-acid battery is switched from the discharging process to the charging process; and
   calculating a sum of the CT values calculated so far when it is determined that the lead-acid battery is switched from the discharging process to the charging process.
(13) The lead-acid battery life estimation method according to (12), wherein, when a section in which the discharge current value changes and a section in which the discharge current value does not change are collectively defined as one section, the determining whether the discharge current value has changed is performed at a time point at which the section is shifted from a section in which the discharge current value does not change to a section in which the discharge current value changes again.
(14) A lead-acid battery life estimation method, including:
   determining whether or not a lead-acid battery is switched from a charging process to a discharging process;
   when it is determined that the lead-acid battery has been switched to the discharging process, starting measurement of an elapse of an integration time in a discharge period of the lead-acid battery;
   measuring a current in the discharging process and integrating the measured discharge current values;
   determining whether the discharge current value has changed;
   determining whether the lead-acid battery is switched from the discharging process to the charging process;
   ending the measurement of the integration time when it is determined that the lead-acid battery is switched from the discharging process to the charging process;
   converting the integration time into a capacity conversion time; and
   executing a calculation process of a CT value using a total discharge capacity obtained by multiplying the ascertained discharge current value by the capacity conversion time.
(15) The lead-acid battery life estimation method according to (14), wherein in the measuring of the integration time, when a section in which the discharge current value changes and a section in which the discharge current value does not change are collectively defined as one section, the measurement of the integration time is started at a time point at which the section in which the discharge current value changes in the one section starts.
(16) The lead-acid battery life estimation method according to (14) or (15), wherein in the converting into the capacity conversion time, the capacity conversion time is calculated by being converted for each of the measured integration times.
(17) The lead-acid battery life estimation method according to any one of (14) to (16), wherein the total discharge capacity is calculated as a sum of the calculated discharge capacities for the respective integration times.
(18) The lead-acid battery life estimation method according to (17), wherein when the discharge capacity calculated for each section shows a negative value, a case where the discharge capacity is included in the total discharge capacity is compared with a case where the discharge capacity is not included in the total discharge capacity, and a case where the discharge capacity shows a larger value of the total discharge capacity is selected as the total discharge capacity.
(19) The lead-acid battery life estimation method according to any one of (12) to (18), further including determining a degradation degree of the lead-acid battery using the calculated CT value after the calculation process of the sum of the CT values.

### Reference Signs List

- 1: BMU
- 2: EMS
- 3: PCS
- 4: Assembled battery sensor
- 11: Sensing input unit
- 12: Recording unit
- 13: State determination unit
- 131: Determination unit
- 132: Current value determination unit
- 133: Calculation unit
- 134: Temperature correction unit
- 135: Degradation determination unit
- 132: Output unit
- 137: Clocking unit
- 14: Setting unit
- 15: Communication control unit
- S: Lead-acid battery system

## Claims

1. A lead-acid battery system comprising:
a transition determination unit configured to determine switching of a charging/discharging process of a lead-acid battery;
a current value determination unit configured to detect a change in a discharge current value during a discharge period of the lead-acid battery;
a calculation unit configured to, when the current value determination unit determines that a change has occurred in the discharge current value, calculate a CT value based on the discharge current value acquired for each section divided by the occurrence of the change; and
a degradation determination unit configured to determine a degradation degree of the lead-acid battery using the CT value calculated by the calculation unit.

2. The lead-acid battery system according to claim 1, wherein, when a section in which the discharge current value changes and a section in which the discharge current value does not change are collectively defined as one section, the current value determination unit determines that a change has occurred in the discharge current value at a time point at which a section in which the discharge current value does not change is shifted again to a section in which the discharge current value changes.

3. The lead-acid battery system according to claim 1, wherein the calculation unit calculates a CT value for each of a plurality of sections, and calculates a sum of the calculated CT values as the CT value in the discharge period.

4. The lead-acid battery system according to claim 1, further comprising a clocking unit configured to measure an elapse of an integration time in the discharge period.

5. The lead-acid battery system according to claim 4, wherein, when a section in which the discharge current value changes and a section in which the discharge current value does not change are collectively defined as one section, the clocking unit starts measuring of the integration time at a time point at which the section in which the discharge current value changes in the one section starts.

6. The lead-acid battery system according to claim 4, wherein the clocking unit ends the measurement of the integration time when the transition determination unit determines that the lead-acid battery has transitioned from the discharge period to a charge period.

7. The lead-acid battery system according to claim 4, wherein the clocking unit ascertains each of the measured integration times, and calculates a capacity conversion time for each of the ascertained integration times.

8. The lead-acid battery system according to claim 5, wherein the current value determination unit ascertains the discharge current value in a section in which the discharge current value does not change in the one section.

9. The lead-acid battery system according to claim 4, wherein the calculation unit starts a calculation process of the CT value when the transition determination unit determines that the discharge period ends after the lead-acid battery transitions from the discharge period to a charge period.

10. The lead-acid battery system according to any one of claims 4 to 9, wherein the calculation unit calculates the discharge capacity for each section by multiplying the capacity conversion time calculated by the clocking unit by the discharge current value that is ascertained, and calculates a sum of the calculated discharge capacities for each integration time as a total discharge capacity.

11. The lead-acid battery system according to claim 10, wherein, when the discharge capacity calculated for each section indicates a negative value, the calculation unit compares a case where the discharge capacity is included in the total discharge capacity with a case where the discharge capacity is not included in the total discharge capacity, and selects a case where the discharge capacity shows a larger value of the total discharge capacity as the total discharge capacity.

12. A lead-acid battery life estimation method, comprising:
determining whether or not a lead-acid battery is switched from a charging process to a discharging process;
measuring a current in the discharging process when it is determined that the lead-acid battery is switched to the discharging process;
integrating measured discharge current values;
determining whether the discharge current value has changed;
executing a calculation process of a CT value using the integrated discharge current value when it is determined that the discharge current value has changed;
determining whether the lead-acid battery is switched from the discharging process to the charging process; and
calculating a sum of the CT values calculated so far when it is determined that the lead-acid battery is switched from the discharging process to the charging process.

13. The lead-acid battery life estimation method according to claim 12, wherein, when a section in which the discharge current value changes and a section in which the discharge current value does not change are collectively defined as one section, the determining whether the discharge current value has changed is performed at a time point at which the section is shifted from a section in which the discharge current value does not change to a section in which the discharge current value changes again.

14. A lead-acid battery life estimation method, comprising:
determining whether or not a lead-acid battery is switched from a charging process to a discharging process;
when it is determined that the lead-acid battery has been switched to the discharging process, starting measurement of an elapse of an integration time in a discharge period of the lead-acid battery;
measuring a current in the discharging process and integrating the measured discharge current values;
determining whether the discharge current value has changed;
determining whether the lead-acid battery is switched from the discharging process to the charging process;
ending the measurement of the integration time when it is determined that the lead-acid battery is switched from the discharging process to the charging process;
converting the integration time into a capacity conversion time; and
executing a calculation process of a CT value using a total discharge capacity obtained by multiplying the ascertained discharge current value by the capacity conversion time.

15. The lead-acid battery life estimation method according to claim 14, wherein, in the measuring of the integration time, when a section in which the discharge current value changes and a section in which the discharge current value does not change are collectively defined as one section, the measurement of the integration time is started at a time point at which the section in which the discharge current value changes in the one section starts.

16. The lead-acid battery life estimation method according to claim 14, wherein, in the converting into the capacity conversion time, the capacity conversion time is calculated by being converted for each of the measured integration times.

17. The lead-acid battery life estimation method according to claim 14, wherein the total discharge capacity is calculated as a sum of the calculated discharge capacities for the respective integration times.

18. The lead-acid battery life estimation method according to claim 17, wherein, when the discharge capacity calculated for each section shows a negative value, a case where the discharge capacity is included in the total discharge capacity is compared with a case where the discharge capacity is not included in the total discharge capacity, and a case where the discharge capacity shows a larger value of the total discharge capacity is selected as the total discharge capacity.

19. The lead-acid battery life estimation method according to any one of claims 12 to 18, further comprising determining a degradation degree of the lead-acid battery using the calculated CT value after the calculation process of the sum of the CT values.
